(19) Europäisches Patentamt
European Patent Office
Office européen des brevets

(11) **EP 2 218 153 B1**

(12) **EUROPÄISCHE PATENTSCHRIFT**

(45) Veröffentlichungstag und Bekanntmachung des Hinweises auf die Patenterteilung:
**03.04.2019 Patentblatt 2019/14**

(21) Anmeldenummer: **08855338.3**

(22) Anmeldetag: **24.10.2008**

(51) Int Cl.:
*H01S 5/32* (2006.01) *H01S 5/20* (2006.01)
*H01S 5/00* (2006.01) *H01S 5/10* (2006.01)
*H01S 5/30* (2006.01) *H01S 5/40* (2006.01)

(86) Internationale Anmeldenummer:
**PCT/DE2008/001734**

(87) Internationale Veröffentlichungsnummer:
**WO 2009/067969 (04.06.2009 Gazette 2009/23)**

(54) **VERFAHREN ZUR HERSTELLUNG EINES STRAHLUNGSEMITTIERENDEN BAUELEMENTS UND STRAHLUNGSEMITTIERENDES BAUELEMENT**

METHOD FOR PRODUCING A RADIATION-EMITTING COMPONENT AND RADIATION-EMITTING COMPONENT

PROCÉDÉ DE FABRICATION D'UN COMPOSANT ÉMETTANT UN RAYONNEMENT ET COMPOSANT ÉMETTANT UN RAYONNEMENT

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **30.11.2007 DE 102007057773**
**20.12.2007 DE 102007061458**

(43) Veröffentlichungstag der Anmeldung:
**18.08.2010 Patentblatt 2010/33**

(73) Patentinhaber: **OSRAM Opto Semiconductors GmbH**
**93055 Regensburg (DE)**

(72) Erfinder:
• **BRICK, Peter**
**93051 Regensburg (DE)**
• **STRAUSS, Uwe**
**93077 Bad Abbach (DE)**

(74) Vertreter: **Epping - Hermann - Fischer Patentanwaltsgesellschaft mbH Schloßschmidstraße 5 80639 München (DE)**

(56) Entgegenhaltungen:
WO-A-2009/039808 JP-A- 2005 116 728
US-A- 5 815 521 US-A1- 2004 013 147
US-A1- 2004 047 379 US-A1- 2005 089 073

• "Section 7.2 Semiconductor Diode Lasers ED - Gupta M C" HANDBOOK OF PHOTONICS, CRC PRESS, BOCA RATON, 1. Januar 1997 (1997-01-01), Seiten 292-298, XP009114823 ISBN: 978-0-8493-8909-2

**Beschreibung**

Die vorliegende Anmeldung betrifft ein strahlungsemittierendes Bauelement. Weiterhin wird zum besseren Verständnis ein Verfahren zur Herstellung eines strahlungsemittierenden Bauelements angegeben.

Bei kantenemittierenden Halbleiterlasern kann die seitens der Auskoppelfacette austretende Strahlung insbesondere eine Schädigung dieser Facette bewirken. Eine solche Schädigung, die zum Ausfall des Halbleiterlasers führt, wird auch als "katastrophaler Spiegelschaden" (engl. Catastrophic Optical Damage, COD) bezeichnet. Je höher die maximale Leuchtdichte im Bereich der Facette ist, desto höher ist die Gefahr eines solchen Schadens.

In der Druckschrift US 2004/0013147 A1 ist ein Diodenlaser mit einem asymmetrischen Brechungsindexprofil beschrieben. Die Schichten des Lasers weisen eine optische Fallenschicht zum Anziehen des optischen Felds und eine Trennschicht auf.

Die Druckschrift US 2004/0047379 A1 beschreibt einen Halbleiterlaser, dessen Nahfeldprofil eine TopHat-Form aufweisen soll. Dies soll durch eine besondere Zusammensetzung einer Ätzstopschicht erzielt werden.

Das Kapitel 7.2 des "Handbook of Photonics" (CRC Press Bova Raton New York, ISBN 0-8493-8909-7) befasst sich mit Halbleiterlaserdioden und deren Kenngrößen, unter anderem auch mit dem räumlichen optischen Profil der Nahfeldemission. Eine Aufgabe ist es, bei einem Festkörperlaser die Gefahr eines Spiegelschadens auch bei hohen Ausgangsleistungen zu vermindern.

Diese Aufgabe wird durch ein strahlungsemittierendes Bauelement gemäß Patentanspruch 1 gelöst. Vorteilhafte Ausgestaltungen und Weiterbildungen sind Gegenstand der abhängigen Patentansprüche.

Weiterhin wird zum besseren Verständnis ein Verfahren zur Herstellung eines strahlungsemittierenden Bauelements angegeben.

Gemäß einem Beispiel wird bei einem Verfahren zur Herstellung eines strahlungsemittierenden Bauelements ein Feldverlauf eines Nahfelds in einer senkrecht zu einer Hauptabstrahlungsachse des Bauelements verlaufenden Richtung vorgegeben. Aus dem Feldverlauf des Nahfelds wird entlang dieser Richtung ein Brechungsindexprofil ermittelt, insbesondere berechnet. Für das Bauelement wird ein Aufbau ermittelt, sodass das Bauelement das zuvor bestimmte Brechungsindexprofil aufweist. Das Bauelement wird gemäß dem zuvor bestimmten Aufbau ausgebildet.

Das Brechungsindexprofil des Bauelements wird also gezielt an einen vorgegebenen Feldverlauf des Nahfelds angepasst ausgebildet. Mit anderen Worten kann aus einem vorgegebenen Nahfeld das Brechungsindexprofil derart berechnet werden, dass das mit diesem Brechungsindexprofil ausgestattete Bauelement den vorgegebenen Feldverlauf des Nahfelds aufweist oder dass das Bauelement zumindest einen diesem vorgegebenen Feldverlauf nahe kommenden tatsächlichen Feldverlauf aufweist. So kann insbesondere ein Feldverlauf des Nahfelds mit einer hohen Homogenität erzielt werden. Je höher die Homogenität des Feldverlaufs ist, desto geringer kann die an einer Resonatorgrenzfläche maximal auftretende lokale optische Felddichte bei gleicher optischer Gesamtausgangsleistung sein. Die Gefahr des Ausfalls des Bauelements aufgrund eines katastrophalen Spiegelschadens kann so vermindert werden.

Unter dem Nahfeld wird insbesondere die Feldverteilung der Strahlung verstanden, die mit dem zur Erzeugung von Strahlung vorgesehenen aktiven Bereich des strahlungsemittierenden Bauelements wechselwirkt und/oder überwiegend in Abstrahlungsrichtung in einem Abstand vom aktiven Bereich auftritt, der im Bereich der Vakuumwellenlänge, insbesondere kleiner oder gleich der Vakuumwellenlänge, der erzeugten Strahlung ist. Auch die Feldverteilung an einer Resonatorgrenzfläche des Bauelements, etwa einer Facette eines Halbleiterlasers, kann herangezogen werden.

In einer bevorzugten Ausgestaltung wird das Brechungsindexprofil mittels folgender Proportionalitätsbeziehung aus dem Nahfeld bestimmt:

$$n \sim [(n_{eff}^2 \, k^2 \, E_N(z) - E_N{''}(z))/(k^2 \, E_N(z))]^{1/2}$$

Hier erstreckt sich die z-Achse senkrecht zu der Hauptabstrahlungsachse des Bauelements, wobei die Hauptabstrahlungsachse durch den Nullpunkt der z-Achse verläuft. $E_N(z)$ ist das elektromagnetische Feld des Nahfelds und $E_N{''}(z)$ dessen zweite Ableitung. k ist der Wellenvektor der elektromagnetischen Strahlung, $n_{eff}$ ist der effektive Brechungsindex.

In einer weiteren bevorzugten Ausgestaltung gilt für die vorgegebene Feldverteilung des Nahfelds die Proportionalitätsbeziehung

$$E_N(z) \sim \exp[-(z/d)^{\alpha}],$$

wobei $\alpha$ eine geradzahlige Zahl größer als 2 und d ein Maß für die Breite der vorgegebenen Feldverteilung des Nahfelds ist. Diese Funktion wird auch als TopHat-Funktion bezeichnet. Im Vergleich zu einer Gauß'schen Funktion, welche sich für α=2 ergeben würde, zeichnet sich die TopHat-Funktion durch steilere Flanken aus, wobei diese umso steiler verlaufen, je größer der Exponent α ist. Zudem weist die TopHat-Funktion im Bereich z < d mit größerem Exponenten α um z = 0 einen immer stärker ausgebildeten Plateau-artigen Verlauf auf.

In einer bevorzugten Ausgestaltung weist das strahlungsemittierende Bauelement einen Halbleiterkörper mit einer Halbleiterschichtenfolge auf, wobei die Halbleiterschichtenfolge weiterhin bevorzugt einen zur Erzeugung von Strahlung vorgesehenen aktiven Bereich aufweist. Der Halbleiterkörper mit der Halbleiterschichtenfolge wird vorzugsweise epitaktisch, etwa mittels MBE oder MOVPE, abgeschieden.

In einer bevorzugten Weiterbildung weist das Bauelement Feldformungsschichten auf, die zumindest auf einer Seite des aktiven Bereichs angeordnet sind. Insbesondere kann das Brechungsindexprofil mittels der Feldformungsschichten gebildet sein.

Weiterhin bevorzugt verläuft das Brechungsindexprofil zumindest teilweise innerhalb des Halbleiterkörpers mit der Halbleiterschichtenfolge.

In einer weiteren bevorzugten Ausgestaltung wird das Brechungsindexprofil mittels einer geeigneten Materialzusammensetzung entlang einer vertikalen Richtung, also entlang einer Abscheiderichtung für die Halbleiterschichtenfolge des Halbleiterkörpers, ausgebildet.

Bevorzugt enthalten die Halbleiterschichten der Halbleiterschichtenfolge zumindest teilweise einen ternären, quaternären oder quinternären Verbindungshalbleiter. Bei derartigen Verbindungshalbleitern ist der Brechungsindex des Materials auf einfache Weise mittels der Materialzusammensetzung einstellbar. Durch Abscheiden von Halbleiterschichten mit unterschiedlichen Brechungsindizes kann also ein Halbleiterkörper mit dem zuvor ermittelten Brechungsindexprofil ausgebildet werden. Der Brechungsindex innerhalb einer Halbleiterschicht muss hierbei nicht notwendigerweise konstant sein. Beispielsweise kann der Brechungsindex einer Halbleiterschicht auch einen Gradienten aufweisen oder stufenförmig ab- oder zunehmen.

Alternativ kann das Brechungsindexprofil mittels einer Strukturierung des Bauelements, insbesondere des Halbleiterkörpers, entlang einer lateralen Richtung, also entlang einer in einer Haupterstreckungsebene der Halbleiterschichten des Halbleiterkörpers verlaufenden Richtung, ausgebildet werden. Auf diese Weise kann das Nahfeld in lateraler Richtung geformt werden. Das Brechungsindexprofil verläuft vorzugsweise senkrecht zur Hauptabstrahlungsachse.

Die Strukturierung kann beispielsweise mittels Ausnehmungen gebildet werden. Diese Ausnehmungen können sich in den Halbleiterkörper hinein erstrecken.

In einer weiteren bevorzugten Ausgestaltung wird der Feldverlauf des Nahfelds entlang einer weiteren senkrecht zu der Hauptabstrahlungsachse des Bauelements verlaufenden Richtung vorgegeben. Das Nahfeld kann also entlang zweier schräg oder senkrecht zueinander stehenden Achsen vorgegeben werden. Basierend auf dem vorgegebenen Feldverlauf des Nahfelds entlang dieser weiteren Richtung kann senkrecht zu der Hauptabstrahlungsachse und schräg oder senkrecht zu dem Brechungsindexprofil ein weiteres Brechungsindexprofil ermittelt werden. Hierbei verläuft das Brechungsindexprofil parallel zur ersten Achse und das weitere Brechungsindexprofil parallel zur zweiten Achse. Nachfolgend kann der Aufbau des Bauelements derart ermittelt werden, dass das Bauelement das zuvor bestimmte weitere Brechungsindexprofil aufweist.

Hierbei kann das weitere Brechungsindexprofil ebenfalls gemäß der im Zusammenhang mit dem Brechungsindexprofil angegebenen Formel aus dem vorgegebenen Nahfeld errechnet werden.

Das ermittelte weitere Brechungsindexprofil kann insbesondere mittels Strukturierung des Halbleiterkörpers in lateraler Richtung und senkrecht zur Hauptabstrahlungsachse verlaufenden Richtung, umgesetzt werden.

In einer bevorzugten Weiterbildung wird das Brechungsindexprofil mittels einer geeigneten Materialzusammensetzung entlang der Abscheiderichtung für die Halbleiterschichtenfolge des Halbleiterkörpers und das weitere Brechungsindexprofil mittels Ausnehmungen in dem Bauelement, insbesondere in dem Halbleiterkörper, gebildet. Insbesondere können sich die Ausnehmungen in die Feldformungsschichten hinein erstrecken. So kann das Nahfeld mittels der Feldformungsschichten entlang der vertikalen Richtung und mittels der Ausnehmungen entlang der lateralen Richtung geformt werden.

Die Ausnehmungen können mittels Entfernens von Material des Halbleiterkörpers mit der Halbleiterschichtenfolge, beispielsweise mechanisch und/oder chemisch, etwa mittels nasschemischen oder trockenchemischen Ätzens, ausgebildet werden.

Die Ausnehmungen können nachfolgend zumindest bereichsweise mit einem Material befüllt werden, das einen größeren oder einen kleineren Brechungsindex aufweist als das Material, in dem die Ausnehmungen ausgebildet sind.

Das Befüllen kann beispielsweise mittels epitaktischen Überwachsens erfolgen. Über die Materialzusammensetzung des epitaktischen Füllmaterials kann so der Brechungsindex in weiten Grenzen variiert werden.

Alternativ oder ergänzend können die Ausnehmungen auch mittels Aufdampfens oder Aufsputterns befüllt werden. Auf den zusätzlichen Epitaxieprozess des Überwachsens kann in diesem Fall verzichtet werden. Beispielsweise kann das Füllmaterial ein dielektrisches Material, etwa ein Oxid, ein Nitrid oder ein Oxinitrid enthalten.

Gemäß einer nicht beanspruchten Ausführungsform weist ein strahlungsemittierendes Bauelement mit einem zur Erzeugung von Strahlung vorgesehenen aktiven Bereich eine Hauptabstrahlungsachse und senkrecht zur Hauptabstrahlungsachse ein Brechungsindexprofil auf. Das Brechungsindexprofil ist derart ausgeführt, dass aufgrund des Brechungsindexprofils eine Feldverteilung eines Nahfelds der im Betrieb des Bauelements erzeugten Strahlung eine höhere Homogenität aufweist als eine Gauß-förmige Feldverteilung.

Die höhere Homogenität wird durch das gezielte Ausbilden des Brechungsindexprofils dergestalt erreicht, dass das resultierende Nahfeld dem vorgegebenen, homogenen Nahfeld entspricht oder zumindest nahe kommt. Dadurch kann die Strahlungsdichte an einer, insbesondere senkrecht zur Hauptabstrahlungsachse stehenden, Resonatorgrenzfläche, welche beispielsweise als eine Spiegelfläche und/oder als eine Strahlungsdurchtrittsfläche dienen kann, besonders homogen ausgebildet werden. Mit anderen Worten wird so die auf die Resonatorgrenzfläche auftreffende Gesamtstrahlungsleistung verbessert über die Resonatorgrenzfläche verteilt. Die maximal auftretende lokale Strahlungsleistungsdichte kann also bei gleicher Gesamtstrahlungsleistung verringert werden. In der Folge kann die Gefahr einer strahlungsbedingten Schädigung der Resonatorgrenzfläche, welche insbesondere am Ort der maximalen Strahlungsleistungsdichte auftreten kann, verringert werden.

Insbesondere kann die maximal auftretende Strahlungsleistungsdichte verringert werden, ohne dass hierfür die Fläche vergrößert werden müsste, auf welche die Strahlung auftrifft. Durch eine Vergrößerung der Fläche bedingte erhöhte Schwellströme und erhöhte Serienwiderstände können, insbesondere im Unterschied zu Lasern mit verbreiterten Wellenleitern, vermieden werden. Solche Laser mit verbreiterten Wellenleitern werden auch als LOC (large optical cavity)-Laser oder SLOC (super-large optical cavity)-Laser bezeichnet. Auch ein ungewolltes vermehrtes Auftreten von lateralen optischen Moden höherer Ordnung kann gegenüber diesen Lasern vereinfacht vermieden oder zumindest vermindert werden. Ein monomodiger Betrieb wird so vereinfacht.

In einer bevorzugten Ausgestaltung steigt das Brechungsindexprofil von der Hauptabstrahlungsachse ausgehend zumindest auf einer Seite, vorzugsweise auf beiden Seiten, der Hauptabstrahlungsachse mit zunehmendem Abstand von der Hauptabstrahlungsachse auf einen, zumindest lokalen, Maximalwert an. Eine Feldformung des Nahfelds kann so besonders effizient erfolgen. Bei dem Maximalwert kann es sich hierbei um ein lokales oder um ein globales Maximum handeln.

Das strahlungsemittierende Bauelement mit einem zur Erzeugung von Strahlung vorgesehenen aktiven Bereich weist eine Hauptabstrahlungsachse und senkrecht zur Hauptabstrahlungsachse ein Brechungsindexprofil auf. Das Brechungsindexprofil steigt von der Hauptabstrahlungsachse ausgehend zumindest auf einer Seite der Hauptabstrahlungsachse mit zunehmendem Abstand von der Hauptabstrahlungsachse auf einen Maximalwert an.

Bei einem derartigen Bauelement kann die abgestrahlte Strahlung im Nahfeld eine besonders homogene Feldverteilung aufweisen.

In einer bevorzugten Weiterbildung ist das Brechungsindexprofil derart ausgeführt, dass aufgrund des Brechungsindexprofils eine Feldverteilung des Nahfelds der im Betrieb des Bauelements erzeugten Strahlung eine höhere Homogenität aufweist als eine Gaußförmige Feldverteilung. Die maximale optische Leistungsdichte an der Strahlungsdurchtrittsfläche kann so vermindert werden.

Unter einem homogenen Nahfeld wird insbesondere ein Nahfeld verstanden, das in einem bestimmten Bereich eine möglichst konstante Intensitätsverteilung aufweist und weiterhin einen vorgegebenen Schwellwert nicht unterschreitet. Je homogener die gesamte Strahlungsleistung über die Strahlungsdurchtrittsfläche verteilt ist, desto kleiner kann die maximale optische Leistungsdichte bei gleich bleibender Gesamtstrahlungsleistung und gleich bleibender Größe der Austrittsfläche sein.

Als Maß für die Homogenität des Nahfelds kann insbesondere die Fläche eines Rechtecks mit maximaler Fläche, das sich unter einer Kurve des Intensitätsverlaufs des Nahfelds erstreckt, herangezogen werden. Das Nahfeld ist hierbei die Intensität der vom strahlungsemittierenden Bauelement abgestrahlten Strahlung als Funktion des Abstands z zur Hauptabstrahlungsachse. Bei einem Nahfeld mit Gauß'scher Feldverteilung beträgt die maximale Rechteckfläche 48,4%.

Ein strahlungsemittierendes Bauelement, bei dem das Nahfeld, insbesondere am Ort der Strahlungsdurchtrittsfläche, eine höhere Homogenität aufweist als eine Gauß-förmige Feldverteilung, ist insbesondere für hohe Ausgangsleistungen, bevorzugt 100 mW oder mehr, besonders geeignet.

In einer bevorzugten Ausgestaltung füllt ein Rechteck mit maximaler Fläche, das sich unter einer Kurve des Intensitätsverlaufs des Nahfelds erstreckt, mindestens 50%, besonders bevorzugt mindestens 60%, am meisten bevorzugt mindestens 65%, der Gesamtfläche unter der Kurve des Intensitätsverlaufs des Nahfelds aus. Je größer diese Fläche ist, desto kleiner kann die lokal auftretende maximale Leistungsdichte bei gleicher optischer Gesamtausgangsleistung sein. Der Intensitätsverlauf ist hierbei der Verlauf des Nahfelds entlang einer parallel zu dem Brechungsindexprofil verlaufenden Richtung.

Der Brechungsindex fällt mit zunehmendem Abstand von der Hauptabstrahlungsachse von dem Maximalwert auf einen Wert ab, der kleiner ist als der Brechungsindex im Bereich der Hauptabstrahlungsachse.

Das Brechungsindexprofil ist symmetrisch zur Hauptabstrahlungsachse ausgebildet. Eine Formung des Nahfelds gemäß einem vorgegebenen Verlauf kann so vereinfacht erzielt werden.

Das Brechungsindexprofil fällt von dem Maximalwert ausgehend zur Hauptabstrahlungsachse hin langsamer ab als in eine Richtung von der Hauptabstrahlungsachse weg.

Weiterhin ist das Brechungsindexprofil zumindest bereichsweise gemäß der Quadratwurzel aus einem Polynom mit geradzahligen Exponenten geformt, wobei auch die 0 als geradzahlige Zahl angesehen wird. Das Polynom weist die Form

$$A + B * z^{\beta} - C * z^{\gamma}$$

auf, wobei A, B und C positive Koeffizienten und $\beta$ und $\gamma$ geradzahlige positive Zahlen mit $\gamma > \beta$ sind. Der Verlauf eines solchen Polynoms steigt von einem Wert A ausgehend mit zunehmendem Abstand z zunächst kontinuierlich auf einen Maximalwert an und fällt nachfolgend vergleichsweise stark ab.

Für einen gemäß einer TopHat-Funktion mit Exponenten $\alpha$ geformten Nahfeldverlauf stellt die Quadratwurzel aus dem obigen Polynom eine analytische Lösung für das Brechungsindexprofil dar, so dass sich folgende Beziehung ergibt

$$n(z) = ( A + B * z^{\alpha-2} - C * z^{2\alpha-2} )^{1/2} .$$

Beispielsweise führt eine TopHat-Funktion mit $\alpha = 4$ zu den Exponenten des Polynoms $\beta = 2$ und $\gamma = 6$, während sich mit $\alpha = 8$ die Exponenten $\beta = 6$ und $\gamma = 14$ ergeben.

Der Koeffizient A kann hierbei aus dem Quadrat des effektiven Brechungsindizes, also aus $n_{eff}^2$, ermittelt werden. Die Koeffizienten B und C können über die Beziehungen

$$B = (\alpha^2 - \alpha) \ / \ [k_{eff}^2 \ d^{\alpha}]$$

und

$$C = \alpha^2 \ / \ [k_{eff}^2 \ d^{2\alpha}]$$

bestimmt werden. Die effektive Wellenzahl $k_{eff}$ ist mit der Vakuumwellenlänge $\lambda$ der sich ausbreitenden Strahlung über die Beziehung $k_{eff} = 2\pi \, n_{eff} / \lambda$ verknüpft.

Insbesondere stimmt das Brechungsindexprofil vorzugsweise in Bereichen mit dem beschriebenen Verlauf überein, in denen das Feld des optischen Mode in lateraler Richtung einen signifikanten Überlapp aufweist. In Bereichen, in die sich nur noch Ausläufer des optischen Mode hinein erstrecken, kann das Brechungsindexprofil auch davon abweichend ausgebildet sein.

Im Rahmen der Anmeldung wird unter dem Brechungsindexprofil der Grundverlauf des Brechungsindizes auf einer für die Formung des elektromagnetischen Strahlungsfelds maßgeblichen Skala verstanden. Insbesondere wirken sich bei einem Halbleiterlaser dünne Schichten, deren Brechungsindex von den angrenzenden Schichten abweicht, nicht wesentlich auf die Feldformung aus und sind daher für das Brechungsindexprofil nicht zu berücksichtigen. Dünne Schichten in diesem Sinn sind insbesondere Quantenschichten des aktiven Bereichs von Halbleiterlasern, die so dünn sind, dass Quantisierungseffekte von Ladungsträgern auftreten können. Die Dicke solcher Quantenschichten beträgt meist weniger als 20 nm.

Ein Halbleiterlaser, bei dem ein aktiver Bereich mit ein oder mehr Quantenschichten in einen Wellenleiter mit konstanter Materialzusammensetzung eingebettet ist, wird daher als ein Halbleiterlaser angesehen, der im Wellenleiter ein konstantes Brechungsindexprofil aufweist, auch wenn der Brechungsindex der Quantenschichten vom Brechungsindex des angrenzenden Materials des Wellenleiters verschieden ist.

Ein solcher Halbleiterlaser mit konstantem Brechungsindexprofil im Bereich des Wellenleiters weist ein resultierendes Nahfeld auf, dessen Verlauf proportional zu $\sin^2(z)$ oder $\cos^2(z)$ ist. Zusammen mit Ausläufern des Nahfelds in die Mantelschichten, zwischen denen der Wellenleiter verläuft, ergibt sich so ein Verlauf, der weitgehend einer Gauß'schen Feldverteilung entspricht. Weiterhin können exponentiell abfallende Nahfelder auch durch voneinander beabstandete Quantentöpfe des aktiven Bereichs verursacht werden. Aufgrund der vergleichsweise geringen Homogenität des Nahfelds ist bei solchen Halbleiterlasern die Gefahr eines katastrophalen Spiegelschadens erhöht.

In einer bevorzugten Ausgestaltung ist das Brechungsindexprofil mittels Feldformungsschichten gebildet, die zumindest auf einer Seite des aktiven Bereichs, bevorzugt beidseits des aktiven Bereichs, angeordnet sind. Weiterhin bevorzugt ist der Maximalwert des Brechungsindexprofils in einer der Feldformungsschichten ausgebildet.

In einer bevorzugten Weiterbildung ist der aktive Bereich zwischen Mantelschichten angeordnet. Die Mantelschichten weisen vorzugsweise einen Brechungsindex auf, der kleiner ist als der Brechungsindex im Bereich der Hauptabstrahlungsachse.

Weiterhin bevorzugt sind die Feldformungsschichten zwischen den Mantelschichten angeordnet. Der Brechungsindex der Feldformungsschichten ist zweckmäßigerweise zumindest bereichsweise höher als der Brechungsindex der Mantelschichten. So kann die laterale Ausbreitung der im aktiven Bereich erzeugten Strahlung zumindest weitgehend auf den Bereich zwischen den Mantelschichten begrenzt werden.

In einer bevorzugten Ausgestaltung weist das Bauelement einen Halbleiterkörper mit einer Halbleiterschichtenfolge auf. Der aktive Bereich ist vorzugsweise in dem Halbleiterkörper ausgebildet. Weiterhin können auch die Feldformungsschichten zumindest teilweise in dem Halbleiterkörper ausgebildet sein. Ferner können die Mantelschichten in den Halbleiterkörper integriert sein oder vollständig oder teilweise außerhalb des Halbleiterkörpers angeordnet sein.

Das Brechungsindexprofil ist vorzugsweise vollständig oder zumindest teilweise in dem Halbleiterkörper ausgebildet. Die Feldformung des Nahfelds kann so zumindest weitgehend innerhalb des Halbleiterkörpers erfolgen.

In einer Ausgestaltungsvariante verläuft das Brechungsindexprofil senkrecht zu einer Haupterstreckungsrichtung der Halbleiterschichten des Halbleiterkörpers. Das Brechungsindexprofil verläuft also entlang einer Abscheiderichtung der Halbleiterschichten des Halbleiterkörpers.

In einer weiteren bevorzugten Weiterbildung enthalten die Feldformungsschichten jeweils ein Verbindungshalbleitermaterial. Weiterhin bevorzugt ist das Brechungsindexprofil mittels einer Variation der Zusammensetzung des Verbindungshalbleitermaterials eingestellt. Anhand der Abhängigkeit des Brechungsindizes von der Materialzusammensetzung kann also aus dem ermittelten Brechungsindexprofil das hierfür erforderliche Profil für die Materialzusammensetzung bestimmt werden. Die relative Änderung dieser Materialkomposition beträgt zwischen dem Bereich um die Hauptabstrahlungsachse und dem Bereich um den Maximalwert bevorzugt zwischen einschließlich 1% und 40%, besonders bevorzugt zwischen einschließlich 5% und 15%.

In einer weiteren bevorzugten Ausgestaltung ist der Maximalwert des Brechungsindexprofils in einer der Feldformungsschichten ausgebildet. Eine Feldformung des Nahfelds wird so vereinfacht.

In einer weiteren Ausgestaltungsvariante verläuft das Brechungsindexprofil in einer Haupterstreckungsebene der Halbleiterschichten des Halbleiterkörpers. So kann das Nahfeld der im Betrieb erzeugten Strahlung in lateraler Richtung gezielt geformt werden.

Ein solches in lateraler Richtung verlaufendes Brechungsindexprofil kann beispielsweise mittels Ausnehmungen gebildet werden. Diese Ausnehmungen können sich in den Halbleiterkörper hinein erstrecken.

In einer bevorzugten Ausgestaltung weist das strahlungsemittierende Bauelement senkrecht zur Hauptabstrahlungsachse und senkrecht zu dem Brechungsindexprofil ein weiteres Brechungsindexprofil auf. Mittels dieses weiteren Brechungsindexprofils kann eine gezielte Formung der Feldverteilung des Nahfelds, insbesondere innerhalb des Halbleiterkörpers, entlang einer zweiten Raumrichtung erzielt werden. Eine flächige homogene Verteilung der gesamten Strahlungsleistung über die Resonatorgrenzfläche, etwa die Strahlungsdurchtrittsfläche, wird so vereinfacht. Die Gefahr einer optischen Spiegelschädigung wird dadurch weitergehend verringert.

Das weitere Brechungsindexprofil kann zumindest eines der im Zusammenhang mit dem Brechungsindexprofil genannten Merkmale aufweisen.

In einer weiteren bevorzugten Ausgestaltung verläuft das Brechungsindexprofil senkrecht zur Haupterstreckungsrichtung der Halbleiterschichten des Halbleiterkörpers und das weitere Brechungsindexprofil ist mittels Ausnehmungen gebildet.

Die Ausnehmungen erstrecken sich vorzugsweise in den Halbleiterkörper, insbesondere in die Feldformungsschichten, hinein. Weiterhin können sich die Ausnehmungen von einer parallel zu einer Haupterstreckungsebene des aktiven Bereichs verlaufenden Oberfläche des Halbleiterkörpers in diesen hinein erstrecken.

Mittels der Ausnehmungen kann für die parallel zur Hauptabstrahlungsachse oszillierende Strahlung der entlang dieser Richtung gemittelte Brechungsindex eingestellt werden. In einer bevorzugten Weiterbildung sind die Ausnehmungen zumindest teilweise mit einem Füllmaterial befüllt. Das Füllmaterial kann einen kleineren Brechungsindex aufweisen als das Material, in dem die Ausnehmungen ausgebildet sind, etwa das an die Ausnehmungen angrenzende Halbleitermaterial. Im Vergleich zum Brechungsindex des Halbleitermaterials kann so der gemittelte Brechungsindex mittels der Ausnehmungen gezielt verändert, insbesondere lokal verringert werden.

Alternativ kann das Füllmaterial einen größeren Brechungsindex aufweisen als das Material, in dem die Ausnehmungen ausgebildet sind, etwa das an die Ausnehmungen angrenzende Halbleitermaterial. Im Vergleich zum Brechungsindex des Halbleitermaterials kann so der gemittelte Brechungsindex mittels der Ausnehmungen gezielt verändert, insbesondere lokal vergrößert werden.

Die Ausnehmungen können auf nur einer Seite des aktiven Bereichs oder auf beiden Seiten des aktiven Bereichs ausgebildet sein. Der aktive Bereich ist vorzugsweise frei von den Ausnehmungen. Eine effiziente Strahlungserzeugung im aktiven Bereich ist so verbessert erzielbar.

In einer weiteren bevorzugten Ausgestaltung weist das Bauelement einen weiteren aktiven Bereich auf, der zur Erzeugung von Strahlung vorgesehen ist. Die insgesamt aus dem Bauelement austretende Strahlungsleistung kann so gesteigert werden.

Zwischen dem aktiven Bereich und dem weiteren aktiven Bereich kann ein Tunnelbereich ausgebildet sein. Mittels dieses Tunnelbereichs können der aktive Bereich und der weitere aktive Bereich elektrisch in Serie miteinander verbunden sein. Der Tunnelbereich ist vorzugsweise mittels zweier Halbleiterschichten gebildet, die jeweils mit zueinander entgegengesetztem Vorzeichen hochdotiert ausgeführt sind. Bevorzugt beträgt die Dotierkonzentration jeweils mindestens $10^{18}$ cm$^{-3}$, besonders bevorzugt mindestens $10^{19}$ cm$^{-3}$.

Die im aktiven Bereich erzeugte Strahlung und die im weiteren aktiven Bereich erzeugte Strahlung können einen gemeinsamen transversalen optischen Mode aufweisen. Diese Strahlungsanteile können also kohärent gekoppelt sein.

In einer Ausgestaltungsvariante ist der weitere aktive Bereich bezüglich des Brechungsindexprofils zwischen der Hauptabstrahlungsachse und der Position des Maximalwerts des Brechungsindexprofils angeordnet. Eine Formung des gemeinsamen transversalen Mode wird so vereinfacht.

In einer alternativen Ausgestaltungsvariante ist die Position des Maximalwerts des Brechungsindexprofils zwischen dem aktiven Bereich und dem weiteren aktiven Bereich angeordnet. Zwischen dem aktiven Bereich und dem weiteren aktiven Bereich kann eine weitere Mantelschicht angeordnet sein. Mittels der Dicke der weiteren Mantelschicht ist die Stärke der optischen Kopplung einstellbar. Der Tunnelbereich kann in der weiteren Mantelschicht ausgebildet sein. Eine Absorption der im aktiven Bereich erzeugten Strahlung im Tunnelbereich kann so weitgehend vermindert werden.

In diesem Fall ist dem weiteren aktiven Bereich vorzugsweise eine weitere Hauptabstrahlungsachse zugeordnet, wobei das Brechungsindexprofil auf der der Hauptabstrahlungsachse abgewandten Seite von der weiteren Hauptabstrahlungsachse ausgehend mit zunehmendem Abstand von der weiteren Hauptabstrahlungsachse auf einen weiteren Maximalwert ansteigt.

Hierbei kann der Verlauf des Brechungsindexprofils relativ zur weiteren Hauptabstrahlungsachse zumindest eines der im Zusammenhang mit dem Verlauf des Brechungsindexprofils relativ zur Hauptabstrahlungsachse beschriebenen Merkmale aufweisen.

Ferner können dem weiteren aktiven Bereich weitere Feldformungsschichten zugeordnet sein. Die Feldformungsschichten, die dem aktiven Bereich zugeordnet sind und die weiteren Feldformungsschichten, die dem weiteren aktiven Bereich zugeordnet sind, können gleichartig ausgebildet sein. Davon abweichend können die Feldformungsschichten und die weiteren Feldformungsschichten voneinander verschieden und insbesondere an den aktiven Bereich beziehungsweise den weiteren aktiven Bereich angepasst sein. Hierbei können der aktive Bereich und der weitere aktive Bereich auch für die Emission von Strahlung mit unterschiedlichen Wellenlängen vorgesehen sein.

Der aktive Bereich und/oder die Feldformungsschichten enthalten vorzugsweise ein Verbindungshalbleitermaterial, besonders bevorzugt ein III-V-Verbindungshalbleitermaterial, insbesondere aus der Materialkombination (AlInGa)(AsPNSb), also einer Kombination von zumindest einem der genannten Elemente aus der dritten Gruppe des Periodensystems mit zumindest einem der genannten Elemente aus der fünften Gruppe des Periodensystems. Das Material kann insbesondere aus der Gruppe bestehend aus $Al_xIn_yGa_{1-x-y}As$, $Al_xIn_yGa_{1-x-y}P$, $Al_xIn_yGa_{1-x-y}N$ und $Al_xIn_yGa_{1-x-y}Sb$, jeweils mit $0 \leq x \leq 1$, $0 \leq y \leq 1$ und $x + y \leq 1$, gewählt sein. Mit diesen Materialien kann Strahlung vom ultravioletten über den sichtbaren bis in den infraroten Spektralbereich auf effiziente Weise erzeugt werden.

Die beschriebene Ausgestaltung des Brechungsindexprofils zur Homogenisierung des Nahfelds und einer dadurch verringerten Gefahr einer optischen Schädigung von Resonatorflächen ist grundsätzlich auf alle kohärenten Emitter anwendbar.

Das strahlungsemittierende Bauelement ist als ein kantenemittierendes Halbleiterlaserbauelement oder als ein oberflächenemittierendes Halbleiterlaserbauelement ausgeführt. Bei einem kantenemittierenden Halbleiterlaserbauelement verläuft die Hauptabstrahlungsachse parallel zu der Haupterstreckungsebene der Halbleiterschichten des Halbleiterkörpers.

Ein oberflächenemittierendes Halbleiterlaserbauelement kann etwa als VCSEL (vertical cavity surface emitting laser), als VECSEL (vertical external cavity surface emitting laser) oder als Scheibenlaser (disk laser) ausgeführt sein. Bei einem oberflächenemittierenden Halbleiterlaserbauelement läuft die Hauptabstrahlungsrichtung des Bauelements senkrecht zu der Haupterstreckungsebene der Halbleiterschichten des Halbleiterkörpers.

Das weiter oben beschriebene Verfahren ist zur Herstellung des strahlungsemittierenden Bauelements besonders geeignet. Im Zusammenhang mit dem strahlungsemittierenden Bauelement ausgeführte Merkmale können daher auch für das Verfahren herangezogen werden und umgekehrt.

Weitere Merkmale, vorteilhafte Ausgestaltungen und Zweckmäßigkeiten ergeben sich aus der folgenden Beschreibung der Ausführungsbeispiele in Verbindung mit den Figuren. Es zeigen:

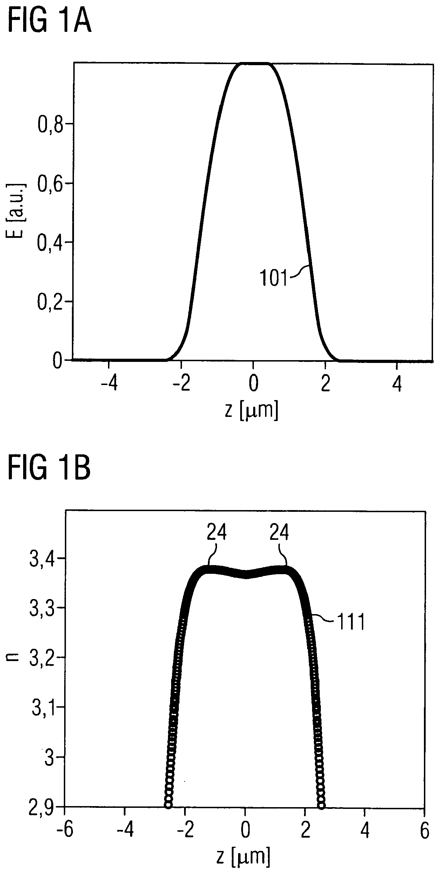

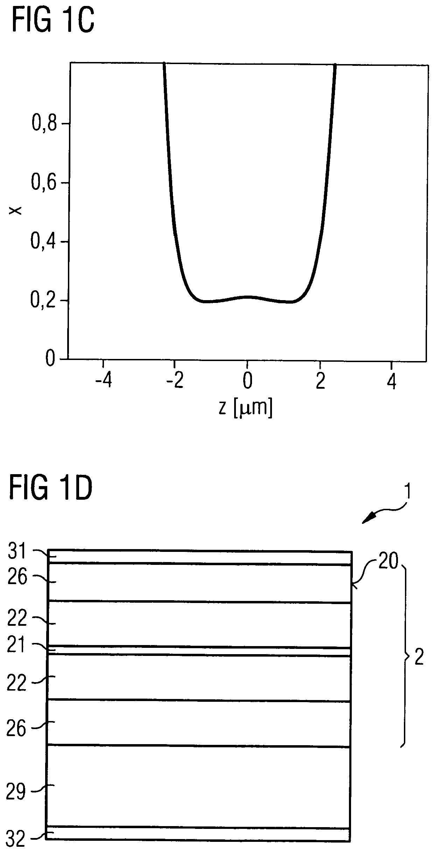

die Figuren 1A bis 1D eine Feldverteilung E(z) eines vorgegebenen Nahfelds (Figur 1A), ein Brechungsindexprofil n(z) (Figur 1B), ein Profil der Materialzusammensetzung (Figur 1C) und eine schematische Schnittansicht eines strahlungsemittierenden Bauelements (Figur 1D) für Zwischenschritte eines ersten Beispiels für ein Verfahren zur Herstellung eines strahlungsemittierenden Bauelements gemäß einem ersten Ausführungsbeispiel,

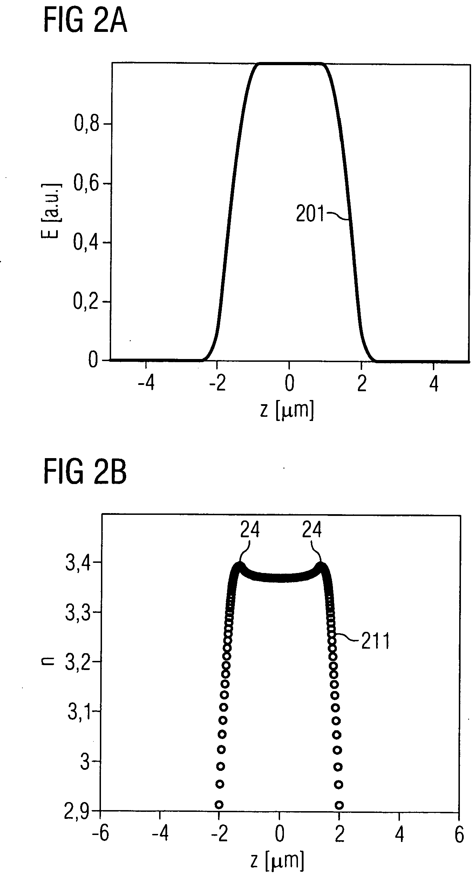

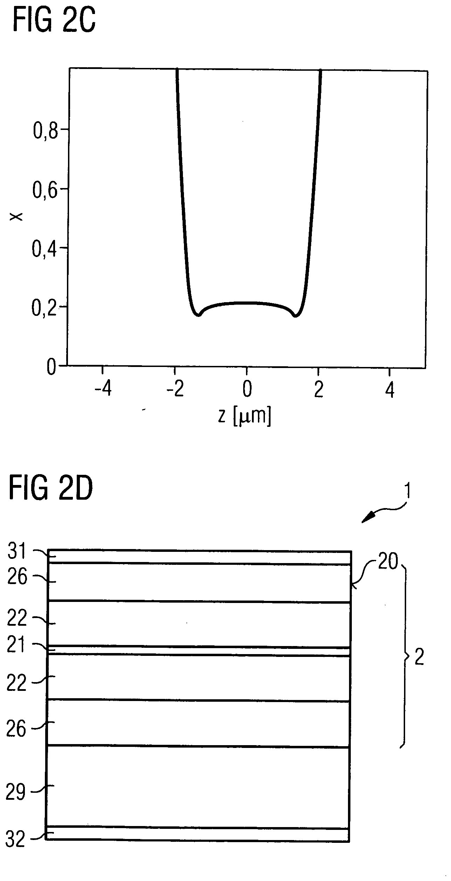

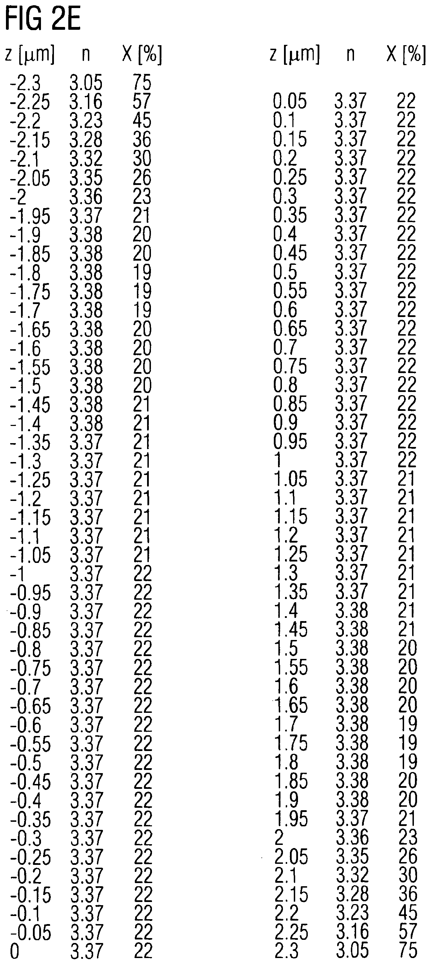

die Figuren 2A bis 2E eine Feldverteilung E(z) eines vorgegebenen Nahfelds (Figur 2A), ein Brechungsindexprofil n(z) (Figur 2B), ein Profil der Materialzusammensetzung (Figur 2C), eine schematische Schnittansicht eines strahlungsemittierenden Bauelements (Figur 2D) und einen zugehörigen Verlauf von Brechungsindex und Materialzusammensetzung in tabellarischer Form (Figur 2E) für Zwischenschritte eines zweiten Beispiels für ein Verfahren zur Herstellung eines strahlungsemittierenden Bauelements gemäß einem zweiten Ausführungsbeispiel,

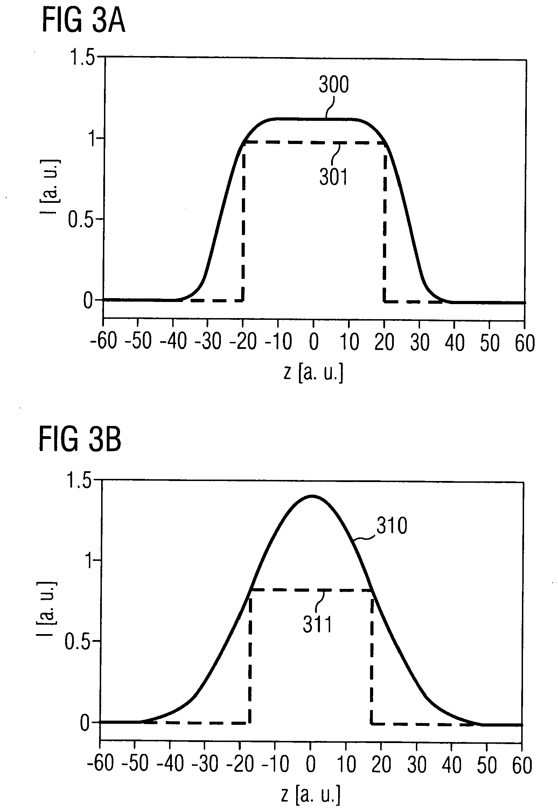

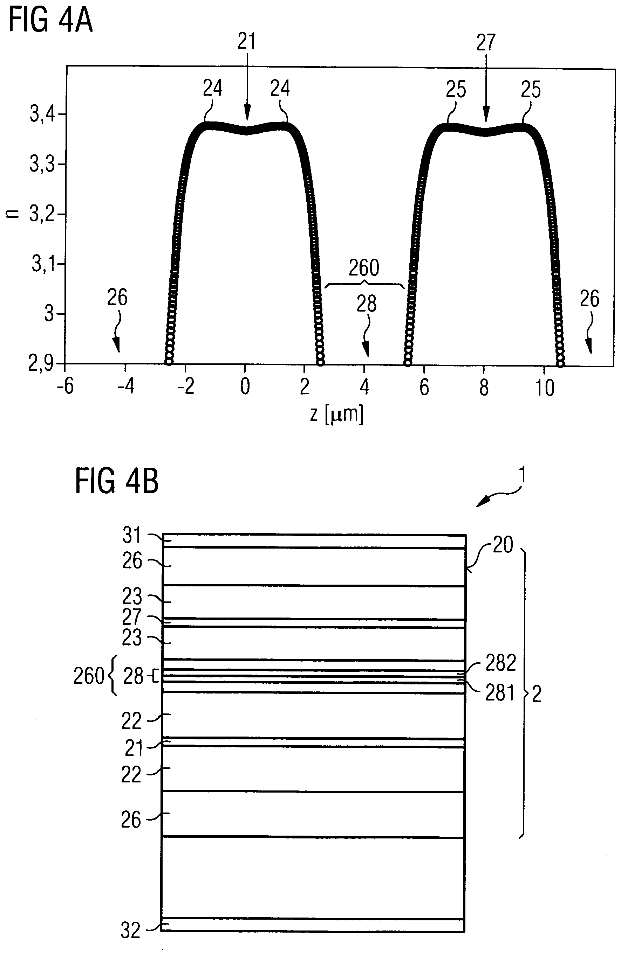

die Figur 3A eine Intensitätsverteilung I des Nahfelds für ein optoelektronisches Bauelement gemäß dem zweiten Ausführungsbeispiel als Funktion des Abstands z zur Hauptabstrahlungsrichtung und die Figur 3B eine Intensitätsverteilung I des Nahfelds gemäß einer Gauß'schen Verteilung, Figur 4A einen qualitativen Verlauf des Brechungsindexprofils für ein strahlungsemittierendes Bauelement gemäß einem in Figur 4B in Schnittansicht dargestellten dritten Ausführungsbeispiel,

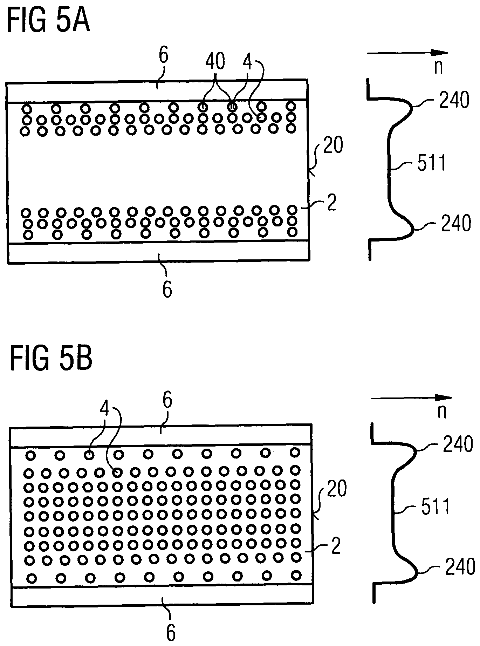

Figur 5A und Figur 5B eine jeweils schematische Darstellung eines viertes beziehungsweise fünftes Ausführungsbeispiels für ein optoelektronisches Bauelement jeweils in Aufsicht mit einem jeweils zugehörigen qualitativen Brechungsindexprofil.

Gleiche, gleichartige und gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

Figur 1A zeigt einen Verlauf der Feldverteilung E eines dem strahlungsemittierenden Bauelement vorgegebenen Nahfelds als Funktion des Abstands z von einer Hauptabstrahlungsachse des strahlungsemittierenden Bauelements. Die z-Achse verläuft also senkrecht zu der Richtung, in welche das strahlungsemittierende Bauelement im Betrieb Strahlung emittiert. Das Nahfeld weist in diesem Ausführungsbeispiel den Verlauf einer TopHat-Funktion mit $\alpha = 4$ auf.

Gegenüber einer Gauß'schen Verteilung zeichnet sich die vorgegebene Feldverteilung also durch eine höhere Homogenität aus.

Aus dem vorgegebenen Nahfeldverlauf kann ein Brechungsindexprofil berechnet werden, das zu dem vorgegebenen Nahfeldverlauf führt.

Für die in Figur 1A dargestellte TopHat-Funktion mit $\alpha = 4$ lässt sich das Brechungsindexprofil n(z) analytisch bestimmen und ergibt sich zu

$$n(z) = ( A + B * z^2 - C * z^6)^{1/2},$$

mit dem oben angegebenen Werten für die Parameter A, B und C. Der entsprechende Verlauf ist in Figur 1B dargestellt.

Von der Hauptabstrahlungsachse ausgehend nimmt das Brechungsindexprofil zunächst kontinuierlich zu und steigt auf beiden Seiten der Hauptabstrahlungsachse jeweils auf einen Maximalwert 24 an. Nachfolgend fällt das Brechungsindexprofil vergleichsweise stark ab und nimmt einen Wert an, der unterhalb des Werts für das Brechungsindexprofil im Bereich der Hauptabstrahlungsachse liegt.

Der so ermittelte Brechungsindexverlauf kann in einen Verlauf der Materialzusammensetzung umgerechnet werden. Diese Umrechnung ist hierbei von dem jeweils für das Bauelement vorgesehenen Material abhängig.

In Figur 1C ist exemplarisch der Verlauf des Aluminiumgehalts x für eine Halbleiterschichtenfolge gezeigt, die auf $Al_xGa_{1-x}As$ basiert. Mit einem entsprechend der Figur 1D ausgebildeten Profil für den Aluminiumgehalt kann also das in Figur 1C dargestellte Brechungsindexprofil umgesetzt werden. Bei $Al_xGa_{1-x}As$ nimmt der Brechungsindex mit zunehmendem Aluminium-Gehalt x ab. Entsprechend weist der Aluminium-Gehalt am Ort des Maximalwerts für den Brechungsindex einen Minimalwert auf.

Die relative Änderung der Materialzusammensetzung beträgt zwischen dem Bereich um die Hauptabstrahlungsachse und dem Bereich um den Maximalwert bevorzugt zwischen einschließlich 1% und 40%, besonders bevorzugt zwischen einschließlich 5% und 15%. Die elektrischen Eigenschaften des strahlungsemittierenden Bauelements werden so durch die Änderung der Materialzusammensetzung nur geringfügig beeinflusst.

Basierend auf dem so ermittelten Aufbau für das Bauelement kann das Bauelement ausgebildet werden.

Wie der Feldverlauf des Nahfelds in Figur 1A zeigt, weist das Nahfeld praktisch ausschließlich in einem Bereich zwischen -2 $\mu$m und +2 $\mu$m um die Hauptabstrahlungsachse von 0 verschiedene Werte auf. Mit anderen Worten ist die Feldstärke außerhalb dieses Bereichs vernachlässigbar. Bei dem herzustellenden strahlungsemittierenden Bauelement reicht es daher aus, das Brechungsindexprofil und somit den daraus errechneten Verlauf der Materialzusammensetzung nur in diesem Bereich umzusetzen. Für größere Werte von z ist die Intensität des Nahfelds so gering, dass auf eine möglichst exakte Nachbildung des errechneten Brechungsindexprofils verzichtet werden kann.

In Figur 1D ist ein derartiges strahlungsemittierendes Bauelement 1 schematisch in Schnittansicht dargestellt. Das strahlungsemittierende Bauelement weist einen Halbleiterkörper 2 mit einer Halbleiterschichtenfolge auf. Die Halbleiterschichtenfolge bildet den Halbleiterkörper und ist vorzugsweise epitaktisch, etwa mittels MOVPE oder MBE, hergestellt. Die Halbleiterschichtenfolge des Halbleiterkörpers 2 ist auf einem Träger 29 angeordnet. Der Träger 29 kann das Aufwachssubstrat sein, auf dem die Halbleiterschichtenfolge des Halbleiterkörpers abgeschieden wurde. Davon abweichend kann der Träger auch vom Aufwachssubstrat verschieden sein. In diesem Fall muss der Träger nicht notwendigerweise die hohen Anforderungen an ein Aufwachssubstrat, insbesondere hinsichtlich der kristallinen Reinheit, erfüllen, sondern kann vielmehr bezüglich anderer Eigenschaften wie thermischer oder elektrischer Leitfähigkeit und/oder mechanischer Stabilität gewählt werden.

Der Halbleiterkörper weist einen aktiven Bereich 21 auf, der im Betrieb des Halbleiterkörpers zur Erzeugung von, vorzugsweise kohärenter, Strahlung vorgesehen ist. Auf beiden Seiten des aktiven Bereichs ist jeweils eine Kontaktschicht 31 beziehungsweise eine weitere Kontaktschicht 32 angeordnet. Die Kontaktschichten dienen vorzugsweise der externen elektrischen Kontaktierung des Halbleiterkörpers 2. Die Kontaktschichten sind vorzugsweise metallisch ausgeführt und können beispielsweise Au, Ti, Pt, Al oder Ag enthalten. Im Betrieb des strahlungsemittierenden Bauelements können Ladungsträger über die Kontaktschichten 31 und 32 von zwei verschiedenen Seiten in den aktiven Bereich injiziert werden und dort unter Emission von Strahlung rekombinieren.

Auf beiden Seiten des aktiven Bereichs 21 ist jeweils eine Feldformungsschicht 22 angeordnet. Auf der dem aktiven Bereich abgewandten Seite der Feldformungsschichten 22 ist jeweils eine Mantelschicht 26 angeordnet. Die Mantelschichten weisen vorzugsweise jeweils einen Brechungsindex auf, der kleiner ist als der Brechungsindex der Feldformungsschichten 22.

Die Mantelschichten können beispielsweise eine Dicke von etwa 1000 nm aufweisen und jeweils $Al_xGa_{1-x}As$, bevorzugt mit $x \geq 0.40$, besonders bevorzugt $x \geq 0.55$ enthalten. Weitergehend kann der Aluminium-Gehalt auch Werte mit $x \geq 0.75$ aufweisen. Hierbei ist der Aluminiumgehalt der Mantelschichten 26 bevorzugt höher als der Aluminiumgehalt der Feldformungsschichten 22 im Bereich der Hauptabstrahlungsachse.

Im Halbleiterkörper oszillierende Strahlung kann so in vertikaler Richtung, also senkrecht zur Haupterstreckungsebene der Halbleiterschichten, zu einem großen Anteil auf den Bereich zwischen den Mantelschichten 26 beschränkt werden.

Von dem dargestellten Ausführungsbeispiel abweichend können die Mantelschichten vollständig oder zumindest teilweise außerhalb des Halbleiterkörpers angeordnet sein. Beispielsweise können die Mantelschichten mittels dielektrischer Schichten gebildet sein, die auf dem Halbleiterkörper 2 abgeschieden sind.

Weiterhin weist der Halbleiterkörper 2 eine Seitenfläche 20 auf, die den Halbleiterkörper in lateraler Richtung, also entlang einer Haupterstreckungsrichtung der Halbleiterschichten des Halbleiterkörpers 2, begrenzt. Zumindest eine der Seitenflächen 20 des Halbleiterkörpers 2 ist zur Auskopplung der im Betrieb des strahlungsemittierenden Bauelements 1 erzeugten kohärenten Strahlung vorgesehen und dient folglich als Strahlungsdurchtrittsfläche. Das strahlungsemittierende Bauelement 1 ist hierbei als ein kantenemittierendes Halbleiterlaserbauelement ausgeführt.

Die Seitenflächen 20 können beispielsweise chemisch, etwa mittels nasschemischen oder trockenchemischen Ätzens, oder mechanisch, etwa mittels Spaltens oder Brechens, hergestellt werden.

Für den aktiven Bereich 21 sind grundsätzlich alle Halbleitermaterialien geeignet, mit denen elektromagnetische Strahlung erzeugt werden kann.

Bevorzugt enthält das strahlungsemittierende Bauelement 1, insbesondere der aktive Bereich 21 und/oder die Feldformungsschichten 22, ein III-V-Verbindungshalbleitermaterial, insbesondere aus einer Materialkombination (AlInGa)(AsPNSb), wobei das Verbindungshalbleitermaterial zumindest eines der genannten Elemente aus der dritten Gruppe und zumindest eines der genannten Elemente aus der fünften Gruppe des Periodensystems enthält.

III-V-Verbindungshalbleitermaterialien sind zur Strahlungserzeugung im ultravioletten ($Al_xIn_yGa_{1-x-y}N$) über den sichtbaren ($Al_xIn_yGa_{1-x-y}N$, insbesondere für blaue bis grüne Strahlung, oder $Al_xIn_yGa_{1-x-y}P$, insbesondere für gelbe bis rote Strahlung) bis in den infraroten ($Al_xIn_yGa_{1-x-y}As$, $Al_xIn_yGa_{1-x-y}Sb$) Spektralbereich besonders geeignet. Hierbei gilt jeweils $0 \leq x \leq 1$, $0 \leq y \leq 1$ und $x + y \leq 1$, insbesondere mit $x \neq 1$, $y \neq 1$, $x \neq 0$ und/oder $y \neq 0$. Mit III-V-Halbleitermaterialien, insbesondere aus den genannten Materialsystemen, können weiterhin bei der Strahlungserzeugung hohe interne Quanteneffizienzen erzielt werden.

Der aktive Bereich 21 enthält vorzugsweise eine Quantenstruktur. Die Quantenstruktur kann hierbei eine Quantenschicht oder zwei oder mehr Quantenschichten aufweisen.

Die Bezeichnung Quantenstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantenstruktur keine Angabe über die Dimensionalität der Quantisierung. Sie umfasst somit unter anderem Quantentröge, Quantendrähte und Quantenpunkte und jede Kombination dieser Strukturen.

Für eine Emission im nahen Infrarot, etwa bei einer Emissionswellenlänge von 1 $\mu$m, eignet sich beispielsweise ein aktiver Bereich mit einer Quantenschicht, die eine Dicke von 10 nm aufweist und auf $In_{0,14}Ga_{0,86}As$ basiert. Insbesondere durch Variation der Schichtdicke und/oder des Indiumgehalts kann die Peak-Wellenlänge der im aktiven Bereich erzeugten Strahlung eingestellt werden.

Zweckmäßigerweise sind die an den aktiven Bereich 21 angrenzenden Halbleiterschichten auf der einen Seite des aktiven Bereichs 21 n-leitend dotiert und die auf der anderen Seite des aktiven Bereichs p-leitend dotiert. Beispielsweise können die zwischen dem aktiven Bereich 21 und dem Träger 29 angeordneten Halbleiterschichten n-leitend dotiert sein und die auf der dem Träger 29 abgewandten Seite des aktiven Bereichs angeordneten Halbleiterschichten p-leitend dotiert sein. Ladungsträger, also Elektronen und Löcher, können so vereinfacht von beiden des aktiven Bereichs 21 injiziert werden und dort unter Emission von Strahlung rekombinieren.

Der Träger 29 ist zweckmäßigerweise elektrisch leitend. Bei einem Träger, der auf Halbleitermaterial, etwa GaAs, Ge, Si oder GaP basiert, ist dieser zweckmäßigerweise gleichartig wie die zwischen dem Träger 29 und dem aktiven Bereich 21 angeordneten Halbleiterschichten 22, 26 dotiert.

Davon abweichend kann der Träger auch elektrisch isolierend ausgebildet sein. In diesem Fall ist die weitere Kontaktschicht 32 zweckmäßigerweise auf der dem aktiven Bereich 21 zugewandten Seite des Trägers 29 angeordnet.

Die Hauptabstrahlungsachse muss nicht notwendigerweise durch den aktiven Bereich verlaufen. Der aktive Bereich 21 kann auch asymmetrisch zum Verlauf des Brechungsindexprofils, also bei einer Position $z \neq 0$, angeordnet sein.

Eine symmetrische Anordnung führt zu einem vergleichsweise großen Überlapp des aktiven Bereichs mit optischen Moden ungeradzahliger Ordnung, welche sich durch ein Maximum der optischen Strahlungsleistung im Bereich der Hauptabstrahlungsachse auszeichnen. Je größer dieser Überlapp ist, desto höher ist der so genannte Confinementfaktor.

Durch die symmetrische Anordnung wird die Unterdrückung geradzahliger Moden vereinfacht. So kann ein monomodiger Betrieb, bei dem lediglich der transversale Mode erster Ordnung anschwingt, vereinfacht erreicht werden. Eine Überlagerung des Nahfelds des Mode erster Ordnung, welcher den oben beschriebenen besonders homogenen vorgegebenen Verlauf zeigt, mit einem weniger homogenen Mode kann so vermieden oder zumindest vermindert werden.

Auch bei einer asymmetrischen Anordnung des aktiven Bereichs 21 kann ein Betrieb im optischen Grundmode erzielt werden.

Eine Unterdrückung von Moden höherer Ordnung kann weitergehend durch eine hohe Dotierung der Mantelschichten 26 und/oder der Außenbereiche der Feldformungsschichen 22 gefördert werden, da die Moden höherer Ordnung einen größeren Überlapp mit weiter von der Hauptabstrahlungsachse entfernten Bereichen aufweisen als Moden niedriger Ordnung. Die so verursachten Verluste bewirken höhere Schwellwerte für ein Anschwingen dieser unerwünschten Moden höherer Ordnung.

Durch das in diesem Beispiel beschriebene Verfahren wird das Brechungsindexprofil 111 dadurch erzielt, dass die Materialzusammensetzung der Halbleiterschichtenfolge des Halbleiterkörpers 2 entlang der Abscheiderichtung, also senkrecht zur Haupterstreckungsrichtung der Halbleiterschichten des Halbleiterkörpers 2, geeignet variiert wird. Das sich so einstellende Brechungsindexprofil 111 bewirkt eine gezielte Formung des Nahfelds. So kann ein Nahfeld erzeugt werden, das im Bereich der Seitenfläche 20 eine hohe Homogenität aufweist. Die maximal auf der Seitenfläche auftretende optische Leistungsdichte kann so bei gleicher Gesamtausgangsleistung der im aktiven Bereich erzeugten Strahlung vermindert werden. Die Gefahr einer Schädigung der Seitenflächen, was zur Zerstörung des Bauelements führen kann, wird so vermindert.

Für die Feldformungsschichten 22 sind hierbei Verbindungshalbleitermaterialien besonders geeignet, bei denen der Brechungsindex mittels einer Variation der Zusammensetzung des Verbindungshalbleitermaterials einstellbar ist.

Auf diese Weise kann ein strahlungsemittierendes Bauelement hergestellt werden, deren abgestrahlte Strahlung im Nahfeld eine höhere Homogenität aufweist als ein Bauelement mit Gaußförmigem Nahfeld.

Ein Rechteck mit maximaler Fläche, das sich unter der Kurve des Intensitätsverlaufs des Nahfelds als Funktion des Abstands zur Hauptabstrahlungsachse erstreckt, füllt vorzugsweise mindestens 50 %, besonders bevorzugt mindestens 60 %, am meisten bevorzugt mindestens 65 %, der Gesamtfläche unter der Kurve des Intensitätsverlaufs des Nahfelds.

Ein derartiges strahlungsemittierendes Bauelement ist als Laser mit einer hohen Ausgangsleistung, etwa 100 mW oder mehr, bevorzugt 1 W oder mehr, besonders geeignet.

Ein weiteres Beispiel für ein Verfahren zur Herstellung eines strahlungsemittierenden Bauelements 1 gemäß einem zweiten Ausführungsbeispiel wird anhand der Figuren 2A bis 2E erläutert. Dieses zweite Beispiel entspricht im Wesentlichen dem im Zusammenhang mit den Figuren 1A bis 1D beschriebenen ersten Ausführungsbeispiel. Im Unterschied hierzu ist die vorgegebene Feldverteilung des Nahfelds 201 durch eine TopHat-Funktion mit $\alpha$ = 8 gegeben. Gegenüber dem in Figur 1A dargestellten Verlauf ist die Feldverteilung weitergehend homogenisiert. Das Plateau-artige Verhalten um $z$ = 0 ist stärker ausgebildet. An den Flanken fällt die Feldverteilung noch schneller ab.

Für den in Figur 2A dargestellten Feldverlauf des Nahfelds 201 kann wiederum das Brechungsindexprofil 211 ermittelt werden, mit dem dieser vorgegebene Verlauf des Nahfelds erzielt werden kann. Die analytische Lösung ist hierbei gegeben durch

$$n(z) = \left( A + B * z^6 - C * z^{14} \right)^{1/2},$$

wobei die Koeffizienten A, B und C die bereits oben angegebenen Werte annehmen.

Das Brechungsindexprofil 211 zeigt wiederum einen Verlauf, bei dem der Brechungsindex von der Hauptabstrahlungsachse ausgehend zu beiden Seiten hin jeweils auf einen Maximalwert 24 ansteigt. Von dem Maximalwert zu größeren z-Werten hin nimmt der Brechungsindex noch stärker ab als bei dem in Figur 1B dargestellten Profil.

Wie im Zusammenhang mit den Figuren 1B und 1C beschrieben, kann aus dem Brechungsindexprofil die hierfür erforderliche Materialzusammensetzung in dem gewünschten Materialsystem ermittelt werden. Der resultierende Aluminium-Gehalt x für das Materialsystem $Al_xGa_{1-x}As$ ist in Figur 2C dargestellt. Den Maximalwerten des Brechungsindexprofils entsprechen wiederum jeweils die Minimalwerte für den Aluminium-Gehalt.

Der in Figur 2D dargestellte Aufbau des strahlungsemittierenden Bauelements 1 entspricht im Wesentlichen dem im Zusammenhang mit Figur 1D beschriebenen strahlungsemittierenden Bauelement. Die Bauelemente unterscheiden sich insbesondere durch das Brechungsindexprofil und das zugehörige Profil des AluminiumGehalts entlang der Abscheiderichtung der Halbleiterschichtenfolge, insbesondere im Bereich der Feldformungsschichten 22.

Mittels des beschriebenen Brechungsindexprofils mit den stärker ausgebildeten Maximalwerten im Randbereich der Feldformungsschichten 22 kann im Betrieb des Bauelements 1 ein Nahfeld erzielt werden, das sich durch eine verbesserte Homogenität auszeichnet. Die maximal an den Seitenflächen 20 auftretende optische Leistungsdichte kann so bei gleicher Gesamtstrahlungsleistung weitergehend verringert werden. Die Gefahr eines katastrophalen Spiegelschadens wird so noch stärker verringert.

Der Verlauf des Brechungsindizes n und des Aluminiumgehalts x für die Feldformungsschichten 22 ist in Figur 2E in tabellarischer Form dargestellt. An der Stelle der Hauptabstrahlungsachse, also bei z = 0, ist der aktive Bereich 21 angeordnet. Die Quantenschicht, die auf $In_{0,14}Ga_{0,86}As$ basiert und eine Dicke von 10 nm aufweist, hat einen Brechungsindex von etwa 3.60. Aufgrund der geringen Dicke wirkt sich diese Quantenschicht jedoch nicht oder zumindest nur in vernachlässigbarer Weise auf den für die Feldverteilung des Nahfelds maßgeblichen Brechungsindexverlauf aus. In der Tabelle ist die Quantenschicht des aktiven Bereichs 21 daher nicht berücksichtigt.

Von z = 0 ausgehend steigt der Brechungsindex in beide Richtungen jeweils auf einen Maximalwert an, der bei z = ±1.75 µm erreicht wird und etwa 3.38 beträgt. Dies wird durch eine Verringerung des Al-Gehalts von 22% im Zentralbereich um die Hauptabstrahlungsachse auf 19% bei z = ±1.75 µm bewerkstelligt. Nachfolgend fällt der Brechungsindex auf einen Wert von 3.05 für z=±2.3µm, was einem Aluminiumgehalt von x=75% entspricht. Die sich daran anschließenden Mantelschichten weisen bevorzugt einen Brechungsindex auf, der höchstens so groß ist wie der Brechungsindex am Rand der Feldformungsschichten, im vorliegenden Beispiel also höchstens 3.05. Der Aluminiumgehalt beträgt demnach vorzugsweise mindestens 75% und kann Werte bis zu 100% annehmen.

Der Intensitätsverlauf eines Nahfelds als Funktion des Abstands z (in willkürlichen Einheiten) zur Hauptabstrahlungsachse des im Zusammenhang mit den Figuren 2A bis 2E beschriebenen Bauelements ist in Figur 3A dargestellt. Der Intensitätsverlauf 300 zeigt in einem Bereich von etwa +/- 15 einen plateauartigen Verlauf, in dem sich die Intensität praktisch nicht verändert. Die gestrichelte Linie 301 bildet hierbei die Umrandung eines Rechtecks mit maximaler Fläche, das unterhalb des Intensitätsverlaufs 300 verläuft. Das Rechteck füllt hierbei etwa 68,8 % der unterhalb der Intensitätskurve 100 ausgebildeten Fläche.

Zum Vergleich zeigt Figur 3B einen entsprechenden Verlauf für eine Gaußförmige Intensitätsverteilung 310. In diesem Fall beträgt die Fläche des Rechtecks maximaler Fläche 311 etwa 48,4 % der von der Intensitätskurve 310 eingeschriebenen Fläche. Das in Figur 3A dargestellte Intensitätsprofil des Nahfelds weist somit eine erheblich höhere Homogenität auf als eine Gaußförmige Intensitätsverteilung.

Ein drittes Ausführungsbeispiel für ein strahlungsemittierendes Bauelement ist in Figur 4B schematisch in Schnittansicht dargestellt. Das zugehörige Brechungsindexprofil 411 ist in Figur 4A gezeigt.

Dieses dritte Ausführungsbeispiel entspricht im Wesentlichen dem im Zusammenhang mit Figur 1D beschriebenen ersten Ausführungsbeispiel. Im Unterschied hierzu weist das strahlungsemittierende Bauelement zusätzlich zum aktiven Bereich 21 einen weiteren aktiven Bereich 27 auf. Der aktive Bereich und der weitere aktive Bereich sind übereinander angeordnet. Durch den weiteren aktiven Bereich kann die insgesamt aus dem Bauelement austretende optische Strahlungsleistung gesteigert werden.

Zwischen dem aktiven Bereich 21 und dem weiteren aktiven Bereich 27 ist ein Tunnelbereich 28 ausgebildet. Der Tunnelbereich 28 ist dafür vorgesehen, den weiteren aktiven Bereich 27 und den aktiven Bereich 21 elektrisch in Serie zu verschalten. Vorzugsweise weist der Tunnelbereich Tunnelschichten 281, 282 auf, wobei beide Schichten besonders bevorzugt hochdotiert sind. Die Dotierkonzentrationen betragen vorzugsweise jeweils mindestens $10^{18}$ cm$^{-3}$,

besonders bevorzugt mindestens $10^{19}$ cm$^{-3}$.

Die Tunnelschichten 281, 282 weisen weiterhin bevorzugt zueinander unterschiedliche Leitungstypen auf, das heißt die eine Tunnelschicht ist n-leitend dotiert, die andere Tunnelschicht ist p-leitend dotiert.

Weiterhin ist zwischen dem aktiven Bereich 21 und dem weiteren aktiven Bereich 27 eine weitere Mantelschicht 260 ausgebildet. Diese kann im Wesentlichen wie die Mantelschichten 26 ausgeführt sein. Über die Dicke der Mantelschicht ist der Abstand zwischen dem aktiven Bereich 21 und dem weiteren aktiven Bereich 27 einstellbar.

Der Tunnelbereich 28 ist vorzugsweise in die weitere Mantelschicht 260 eingebettet. In diesem Fall können die Tunnelschichten des Tunnelbereichs 28 abgesehen von der Dotierung dieselbe Materialzusammensetzung aufweisen wie die weitere Mantelschicht 260. Im Bereich der Mantelschichten ist die Intensität des Nahfelds aufgrund des niedrigen Brechungsindizes vergleichsweise gering. Eine Absorption der im Betrieb erzeugten Strahlung durch die hochdotierten Schichten des Tunnelbereichs 28 kann so weitgehend vermindert werden.

Der weitere aktive Bereich 27 ist zwischen weiteren Feldformungsschichten 23 angeordnet. Der aktive Bereich 21 und der weitere aktive Bereich 27 sind in diesem Ausführungsbeispiel gleichartig ausgeführt.

Weiterhin sind die Feldformungsschichten 22 und die weiteren Feldformungsschichten 23 gleichartig ausgeführt. Durch den weiteren aktiven Bereich verläuft also parallel zur Hauptabstrahlungsachse eine weitere Hauptabstrahlungsachse. Von der weiteren Hauptabstrahlungsachse steigt der Brechungsindex in beide Richtungen jeweils auf einen weiteren Maximalwert 25 und fällt mit zunehmendem Abstand stark ab. Das Brechungsindexprofil ist im Bereich der Feldformungsschichten 22 beziehungsweise der weiteren Feldformungsschichten 23 jeweils wie im Zusammenhang mit Figur 1B beschrieben ausgeführt. Davon abweichend kann das Brechungsindexprofil in einem oder in beiden dieser Bereiche auch einen anderen Verlauf, insbesondere einen gemäß dem in Figur 2B dargestellten Verlauf aufweisen.

Mittels der weiteren Mantelschicht 260 sind der aktive Bereich 21 und der weitere aktive Bereich 27 voneinander entkoppelt. Die aktiven Bereiche 21 und 27 können also weitgehend unabhängig voneinander kohärente Strahlung erzeugen. Der Grad der Kopplung der im aktiven Bereich 21 und im weiteren aktiven Bereich 27 erzeugten Strahlung ist hierbei über die Dicke der weiteren Mantelschicht einstellbar. Je geringer die Dicke der weiteren Mantelschicht ist, desto stärker ist die kohärente Kopplung zwischen diesen aktiven Bereichen. Bei einer geringeren Dicke der Mantelschichtkönnen der aktive Bereich 21 und der weitere aktive Bereiche 27 also kohärent gekoppelt sein. Das heißt, die im aktiven Bereich erzeugte Strahlung und die in den weiteren aktiven Bereichen erzeugte Strahlung weisen einen gemeinsamen transversalen optischen Mode auf.

Von dem gezeigten Ausführungsbeispiel abweichend können der aktive Bereich und der weitere aktive Bereich zwischen zwei benachbarten Maximalwerten des Brechungsindexprofils angeordnet sein. Auf die weitere Mantelschicht zwischen dem aktiven Bereich und dem weiteren aktiven Bereich kann in diesem Fall auch verzichtet werden..

In den Figuren 5A und 5B ist ein viertes beziehungsweise fünftes Ausführungsbeispiel für ein strahlungsemittierendes Bauelement jeweils schematisch in Aufsicht dargestellt. Weiterhin ist für beide Ausführungsbeispiele qualitativ der Verlauf des zugehörigen Brechungsindexprofils dargestellt. Diese Brechungsindexprofile verlaufen also im Unterschied zu den vorangegangenen Ausführungsbeispielen in lateraler Richtung.

Zusätzlich kann der Halbleiterkörper auch in vertikaler Richtung ein Brechungsindexprofil aufweisen, mit dem das Nahfeld wie oben in vertikaler Richtung beschrieben homogenisiert werden kann. Die vertikale Struktur des Halbleiterkörpers 2 mit der Halbleiterschichtenfolge kann hierbei beispielsweise wie in den im Zusammenhang mit den Figuren 1D, 2D oder 4B beschriebenen Ausführungsbeispielen mit den jeweils zugehörigen Brechungsindexprofilen ausgeführt sein.

Der Halbleiterkörper 2 weist Ausnehmungen 4 auf, die sich seitens einer senkrecht zur Seitenfläche 20 stehenden Oberfläche in den Halbleiterkörper hinein erstrecken. Die Oberfläche des Halbleiterkörpers verläuft dabei parallel zum aktiven Bereich. Die Ausnehmungen erstrecken sich von der Oberfläche in Richtung des aktiven Bereichs 21. Bevorzugt erstrecken sich die Ausnehmungen nicht durch den aktiven Bereich hindurch. Die effiziente Erzeugung von Strahlung im aktiven Bereich wird so vereinfacht. Die Ausnehmungen können sich von einer Seite oder von beiden Seiten des aktiven Bereichs in Richtung des aktiven Bereichs erstrecken.

Die Ausnehmungen 4 sind vorzugsweise derart ausgeführt und angeordnet, dass sich in lateraler Richtung, also senkrecht zur Hauptabstrahlungsachse und senkrecht zur Abscheiderichtung der Halbleiterschichtenfolge des Halbleiterkörpers ein Brechungsindexprofil ergibt, durch das sich ein in lateraler Richtung vorgegebenes Nahfeld einstellt.

Zusammen mit einem Brechungsindexprofil in vertikaler Richtung, das insbesondere wie in den im Zusammenhang mit den Figuren 1D, 2D oder 4B beschriebenen Ausführungsbeispielen ausgeführt sein kann, kann das Nahfeld bezüglich zweier zueinander senkrechter Achsen gemäß einem vorgegebenen Verlauf geformt werden. Insbesondere kann so ein Nahfeld ausgebildet werden, das entlang diesen beiden Richtungen eine hohe Homogenität aufweist. Die durch die Seitenfläche 20 hindurchtretende Strahlung kann so besonders homogen verteilt werden. Dies kann zu einer verringerten maximal auftretenden optischen Leistungsdichte an der Seitenfläche führen. Die Gefahr eines katastrophalen Spiegelschadens wird so weitergehend verringert.

In dem Halbleiterkörper 2 sind beispielhaft gleichartige Ausnehmungen 4 ausgebildet, wobei der parallel zur der Hauptabstrahlungsachse gemittelte effektive Brechungsindex bei der Herstellung des Bauelements über die Dichte der Ausnehmungen eingestellt werden kann.

Gemäß dem in Figur 5A gezeigten Ausführungsbeispiel sind die Ausnehmungen mit einem Füllmaterial 40 befüllt, das einen größeren Brechungsindex aufweist als das die Ausnehmungen umgebende Material. Je höher also die Dichte der Ausnehmungen ist, desto größer ist der parallel zur Hauptabstrahlungsachse gemittelte Brechungsindex in einem vorgegebenen Abstand von der Hauptabstrahlungsachse. Auf diese Weise kann in lateraler Richtung beispielsweise ein weiteres Brechungsindexprofil 511 eingestellt werden, bei dem der Brechungsindex ausgehend von der Hauptabstrahlungsachse auf einen Maximalwert 240 ansteigt und nachfolgend abfällt. Das weitere Brechungsindexprofil kann also bezüglich des qualitativen Verlaufs ähnlich dem im Zusammenhang mit den Figuren 1B und 2B beschriebenen Brechungsindexverlauf ausgeführt sein.

Das Befüllen der Ausnehmungen kann beispielsweise mittels epitaktischen Überwachsens der Ausnehmungen erfolgen. Beispielsweise können Ausnehmungen in einer $Al_xGa_{1-x}As$-Halbleiterschicht mit einem $Al_xGa_{1-x}As$-Material befüllt werden, das einen geringeren Al-Gehalt und somit einen höheren Brechungsindex aufweist.

Für die Ausnehmungen können verschiedene geometrische Formen zweckmäßig sein. Beispielsweise können die Ausnehmungen runde, elliptische und mehreckige, insbesondere rechteckige Grundformen aufweisen. Auch grabenartige Ausnehmungen, die sich insbesondere parallel zur Hauptabstrahlungsachse erstrecken können, können Anwendung finden.

In lateraler Richtung ist auf beiden Seiten des Halbleiterkörpers eine Randschicht 6 angeordnet. Der Brechungsindex der Randschichten ist zweckmäßigerweise kleiner als der Brechungsindex des Halbleiterkörpers. Die Randschichten 6 enthalten vorzugsweise ein dielektrisches Material, insbesondere eines der im Zusammenhang mit dem Füllmaterial 6 genannten dielektrischen Materialien. Alternativ kann auf die Randschicht auch verzichtet werden.

Durch die Umsetzung des weiteren Brechungsindexprofils kann ein strahlungsemittierende Bauelement derart ausgeführt werden, dass die Feldverteilung des Nahfelds entlang zweier zueinander senkrecht stehenden Achsen einem vorgegebenen, insbesondere besonders homogenen, Verlauf entspricht oder zumindest nahe kommt. Die Gefahr eines katastrophalen Spiegelschadens kann so auch bei hohen insgesamt austretenden Strahlungsleistungen weitgehend verringert werden.

Das in Figur 5B schematisch dargestellte fünfte Ausführungsbeispiel entspricht im Wesentlichen dem im Zusammenhang mit Figur 5A beschriebenen vierten Ausführungsbeispiel. Insbesondere sind die Ausnehmungen 4 wie bei dem vierten Ausführungsbeispiel zur Variation des parallel zur Hauptabstrahlungsachse gemittelten Brechungsindizes vorgesehen. Im Unterschied zum vierten Ausführungsbeispiel sind die Ausnehmungen jedoch nicht befüllt oder zumindest bereichsweise mit einem Füllmaterial befüllt, das einen niedrigeren Brechungsindex aufweist als das angrenzende Halbleitermaterial. Der gemittelte Brechungsindex kann so gezielt verringert werden.

Je höher in diesem Fall die Dichte der Ausnehmungen ist, desto kleiner ist dieser gemittelte Brechungsindex. Mittels der Ausnehmungen nahe der Hauptabstrahlungsachse kann der gemittelte Brechungsindex also gezielt verringert werden, so dass sich wiederum wie im Zusammenhang mit Figur 5A beschrieben Maximalwerte 240 für das Brechungsindexprofil einstellen.

Insbesondere Füllmaterial, das einen geringeren Brechungsindex aufweist als das Material des Halbleiterkörpers 2, kann mittels Aufdampfens oder Aufsputterns aufgebracht werden. Beispielsweise eignet sich als Füllmaterial dielektrisches Material, insbesondere ein Oxid, etwa Siliziumoxid oder Titanoxid, ein Nitrid, etwa Siliziumnitrid oder ein Oxinitrid, etwa Siliziumoxinitrid. In diesem Fall kann das Füllmaterial gleichzeitig als Passivierungsschicht für den Halbleiterkörper dienen.

Alternativ kann auch Halbleitermaterial mit geringerem Brechungsindex mittels epitaktischen Überwachsens als Füllmaterial abgeschieden werden.

Diese Patentanmeldung beansprucht die Priorität der deutschen Patentanmeldungen 10 2007 057 773.9 und 10 2007 061 458.8.

**Patentansprüche**

1. Strahlungsemittierendes Bauelement, das als ein kantenemittierendes oder oberflächenemittierendes Halbleiterlaserbauelement ausgeführt ist, mit einem zur Erzeugung von Strahlung vorgesehenen aktiven Bereich (21), das eine Hauptabstrahlungsachse und senkrecht zur Hauptabstrahlungsachse ein Brechungsindexprofil (111, 211) aufweist, wobei das Brechungsindexprofil (111, 211) von der Hauptabstrahlungsachse ausgehend auf beiden Seiten der Hauptabstrahlungsachse mit zunehmendem Abstand von der Hauptabstrahlungsachse auf einen Maximalwert (24) ansteigt, wobei das Brechungsindexprofil symmetrisch zur Hauptabstrahlungsachse ausgebildet ist, und wobei der Brechungsindex mit zunehmendem Abstand von der Hauptabstrahlungsachse von dem Maximalwert (24) auf einen Wert abfällt, der kleiner ist als der Brechungsindex im Bereich der Hauptabstrahlungsachse, wobei das Brechungsindexprofil (111, 211, 511) von dem Maximalwert (24) ausgehend zur Hauptabstrahlungsachse hin langsamer abfällt als von der Hauptabstrahlungsachse weg.

**2.** Strahlungsemittierendes Bauelement nach Anspruch 1,
das Feldformungsschichten aufweist, die zumindest auf einer Seite des aktiven Bereichs (21) angeordnet sind, wobei das Brechungsindexprofil (111, 211) mittels der Feldformungsschichten gebildet ist.

**3.** Strahlungsemittierendes Bauelement nach Anspruch 1 oder 2, bei dem das Brechungsindexprofil von der Hauptabstrahlungsachse ausgehend kontinuierlich auf den Maximalwert ansteigt.

**4.** Strahlungsemittierendes Bauelement nach einem der Ansprüche 1 bis 3,
bei dem das Brechungsindexprofil (111, 211, 511) bereichsweise gemäß der Quadratwurzel aus einem Polynom mit geradzahligen Exponenten geformt ist.

**5.** Strahlungsemittierendes Bauelement nach Anspruch 4,
bei dem das Polynom die Form

$$A + B * z^{\beta} - C * z^{\gamma}$$

aufweist, wobei A, B und C positive Koeffizienten und $\beta$ und $\gamma$ geradzahlige positive Zahlen mit $\gamma > \beta$ sind und z der Abstand zur Hauptabstrahlungsachse ist.

**6.** Strahlungsemittierendes Bauelement nach einem der Ansprüche 1 bis 5,
bei dem das Nahfeld einen Intensitätsverlauf (300) aufweist, dem ein sich unter einer in linearer Skala dargestellten Kurve des Intensitätsverlaufs erstreckendes Rechteck mit maximaler Fläche (301) zugeordnet ist, das mindestens 50%, vorzugsweise mindestens 60%, der Gesamtfläche unter der Kurve des Intensitätsverlaufs des Nahfelds ausfüllt.

**7.** Strahlungsemittierendes Bauelement nach einem der Ansprüche 1 bis 6,
bei dem das Bauelement (1) einen Halbleiterkörper (2) mit einer Halbleiterschichtenfolge aufweist, wobei der aktive Bereich (21) in dem Halbleiterkörper (2) ausgebildet ist und bei dem das Brechungsindexprofil (111, 211) senkrecht zu einer Haupterstreckungsrichtung der Halbleiterschichten des Halbleiterkörpers (2) verläuft.

**8.** Strahlungsemittierendes Bauelement nach einem der Ansprüche 1 bis 6,
bei dem das Bauelement (1) einen Halbleiterkörper (2) mit einer Halbleiterschichtenfolge aufweist, wobei der aktive Bereich (21) in dem Halbleiterkörper (2) ausgebildet ist und bei dem das Brechungsindexprofil (511) in einer Haupterstreckungsebene der Halbleiterschichten des Halbleiterkörpers (2) verläuft.

**9.** Strahlungsemittierendes Bauelement nach einem der Ansprüche 1 bis 6,
bei dem das Bauelement (1) einen Halbleiterkörper (2) mit einer Halbleiterschichtenfolge aufweist, wobei der aktive Bereich (21) in dem Halbleiterkörper (2) ausgebildet ist und bei dem das Brechungsindexprofil (111, 211) senkrecht zu einer Haupterstreckungsrichtung der Halbleiterschichten des Halbleiterkörpers (2) verläuft und ein weiteres Brechungsindexprofil (511) in entlang einer in einer Haupterstreckungsebene der Halbleiterschichten des Halbleiterkörpers (2) verlaufenden lateralen Richtung mittels Ausnehmungen (4) gebildet ist.

**10.** Strahlungsemittierendes Bauelement nach einem der Ansprüche 1 bis 6,
das einen weiteren aktiven Bereich (27) umfasst, der zur Erzeugung von Strahlung vorgesehen ist und bei dem die im aktiven Bereich (21) erzeugte Strahlung und die im weiteren aktiven Bereich (27) erzeugte Strahlung einen gemeinsamen transversalen optischen Mode aufweisen.

**11.** Strahlungsemittierendes Bauelement nach Anspruch 10,
bei dem der weitere aktive Bereich (27) bezüglich des Brechungsindexprofils (111, 211) zwischen der Hauptabstrahlungsachse und der Position des Maximalwerts (24) des Brechungsindexprofils (111, 211) angeordnet ist.

**Claims**

**1.** Radiation-emitting component, which is formed as an edge-emitting or surface-emitting semiconductor laser component, comprising an active region (21) provided for the emission of radiation, a main emission axis and an index of refraction profile (111, 211) perpendicular to the main emission axis, wherein the index of refraction profile (111, 211) increases from the main emission axis on both sides of the main emission axis with increasing distance from the main emission axis to a maximum value (24), wherein the index of refraction profile is formed symmetrically to the main emission axis, and

wherein, with increasing distance from the main emission axis, the index of refraction decreases from the maximum value (24) to a value smaller than the index of refraction in the area of the main emission axis, wherein the index of refraction profile (111, 211, 511) decreases, starting from the maximum value (24), more slowly towards the main emission axis than away from the main emission axis.

2. Radiation-emitting component according to claim 1, comprising field-shaping layers that are arranged at least on one side of the active region (21), wherein the index of refraction profile (111, 211) is formed by the field-shaping layers.

3. Radiation-emitting component according to claim 1 or 2, wherein starting from the main emission axis, the index of refraction profile increases continuously to a maximum value.

4. Radiation-emitting component according to one of claims 1 through 3, wherein the index of refraction profile (111, 211, 511) is shaped in in places according to the square root of a polynomial with even-numbered exponents.

5. Radiation-emitting component according to claim 4, wherein the polynomial has the form

$$A + B * z^\beta - C * z^\gamma$$

where A, B and C are positive coefficients and $\beta$ and $\gamma$ are positive even numbers with $\gamma > \beta$ and z is the distance to the main emission axis.

6. Radiation-emitting component according to one of claims 1 through 5, in which the near field has an intensity distribution (300) with which a rectangle with maximum area (301) underneath a linearly scaled curve of the intensity distribution is associated that fills out at least 50 %, preferably at least 60 % of the total surface area underneath the curve of the intensity distribution.

7. Radiation-emitting component according to one of claims 1 through 6, in which the component (1) has a semiconductor body (2) with a semiconductor layer sequence, wherein the active region (21) is formed in the semiconductor body (2) and in which the index of refraction profile (111, 211) runs perpendicular to a main extension direction of the semiconductor layers of the semiconductor body (2).

8. Radiation-emitting component according to one of claims 1 through 6, in which the component (1) has a semiconductor body (2) with a semiconductor layer sequence, wherein the active region (21) is formed in the semiconductor body (2) and in which the index of refraction profile (511) runs in a main extension plane of the semiconductor layers of the semiconductor body (2).

9. Radiation-emitting component according to one of claims 1 through 6, in which component (1) has a semiconductor body (2) with a semiconductor layer sequence, wherein active region (21) is formed in semiconductor body (2) and in which index of refraction profile (111, 211) runs perpendicular to a main extension direction of the semiconductor layers of semiconductor body (2), and by means of recesses (4) an additional index of refraction profile (511) is formed in the lateral direction running along an extension plane of the semiconductor layer sequence of the semiconductor body (2).

10. Radiation-emitting component according to one of claims 1 through 6, that comprises an additional active region (27) that is provided to generate radiation, and in which the radiation generated in active region (21) and the radiation generated in additional active region (27) have a common transversal optical mode.

11. Radiation-emitting component according to claim 10, in which the additional active region (27) is arranged relative to the index of refraction profile (111, 211) between the main emission axis and the position of the maximum value (24) of the index of refraction profile (111, 211).

**Revendications**

1. Composant émetteur de rayonnement, qui est réalisé comme un composant laser à semiconducteur à émission par la tranche ou de surface, avec une zone active (21) prévue en vue de la production de rayonnement, qui présente un axe de rayonnement principal et perpendiculairement à l'axe de rayonnement principal, un profil d'indice de réfraction (111, 211),
le profil d'indice de réfraction (111, 211) augmentant en partant de l'axe de rayonnement principal des deux côtés de l'axe de rayonnement principal avec un écart croissant par rapport à l'axe de rayonnement principal à une valeur maximale (24), le profil d'indice de réfraction étant constitué symétriquement à l'axe de rayonnement principal, et
le profil d'indice de réfraction tombant avec l'écart croissant par rapport à l'axe de rayonnement principal de la valeur maximale (24) à une valeur, qui est inférieure à l'indice de réfraction dans la zone de l'axe de rayonnement principal, le profil d'indice de réfraction (111, 211, 511) tombant plus lentement en partant de la valeur maximale (24) vers l'axe de rayonnement principal qu'en s'écartant de l'axe de rayonnement principal.

2. Composant émetteur de rayonnement selon la revendication 1,
qui présente des couches de moulage des champs, qui sont disposées au moins sur un côté de la zone active (21),
le profil d'indice de réfraction (111, 211) étant constitué au moyen des couches de moulage des champs.

3. Composant émetteur de rayonnement selon la revendication 1 ou 2,
pour lequel le profil d'indice de réfraction augmente continuellement à la valeur maximale en partant de l'axe de rayonnement principal.

4. Composant émetteur de rayonnement selon une quelconque des revendications 1 à 3,
pour lequel le profil d'indice de réfraction (111, 211, 511) est formé par zones selon la racine carré à partir d'un polynôme avec des exposants pairs.

5. Composant émetteur de rayonnement selon la revendication 4, pour lequel le polynôme présente la forme

$$A + B * z^\beta - C * z^\gamma$$

A, B et C étant des coefficients positifs et $\beta$ et $\gamma$ des nombres positifs pairs avec $\gamma > \beta$, et z étant l'écart par rapport à l'axe de rayonnement principal.

6. Composant émetteur de rayonnement selon une quelconque des revendications 1 à 5,
pour lequel le champ proche présente une évolution de l'intensité (300) à laquelle est affecté avec une surface maximale (301) un rectangle s'étendant au-dessous d'une courbe de l'évolution de l'intensité représentée en graduation linéaire, qui remplit au moins 50 %, de préférence au moins 60 % de la surface totale sous la courbe de l'évolution de l'intensité du champ proche.

7. Composant émetteur de rayonnement selon une quelconque des revendications 1 à 6,
pour lequel le composant (1) présente un corps semiconducteur (2) avec une succession de couches semiconductrices, la zone active (21) étant constituée dans le corps semiconducteur (2) et pour laquelle le profil d'indice de réfraction (111, 211) se produit perpendiculairement à une direction d'extension principale des couches semiconductrices du corps semiconducteur (2).

8. Composant émetteur de rayonnement selon une quelconque des revendications 1 à 6,
pour lequel le composant (1) présente un corps semiconducteur (2) avec une succession de couches semiconductrices, la zone active (21) étant constituée dans le corps semiconducteur (2) et pour laquelle le profil d'indice de réfraction (511) se produit sur un plan d'extension principal des couches semiconductrices du corps semiconducteur (2).

9. Composant émetteur de rayonnement selon une quelconque des revendications 1 à 6,
pour lequel le composant (1) présente un corps semiconducteur (2) avec une succession de couches semiconductrices, la zone active (21) étant constituée dans le corps semiconducteur (2) et pour laquelle le profil d'indice de réfraction (111, 211) se produit perpendiculairement à une direction d'extension principale des couches semiconductrices du corps semiconducteur (2) et un autre profil d'indice de réfraction (511) est constitué au moyen de creux (4) dans une direction latérale se produisant le long d'un plan d'extension principal des couches semiconductrices du corps semiconducteur (2).

10. Composant émetteur de rayonnement selon une quelconque des revendications 1 à 6, qui comporte une autre zone active (27), qui est prévue en vue de la production de rayonnement et pour laquelle le rayonnement produit dans la zone active (21) et le rayonnement produit dans l'autre zone active (27) présentent un mode optique transversal commun.

11. Composant émetteur de rayonnement selon la revendication 10, pour lequel l'autre zone active (27) concernant le profil d'indice de réfraction (111, 211) est disposée entre l'axe de rayonnement principal et la position de la valeur maximale (24) du profil d'indice de réfraction (111, 211).

FIG 1A

FIG 1B

## FIG 1C

## FIG 1D

# FIG 2A

# FIG 2B

## FIG 2C

## FIG 2D

## FIG 2E

| z [μm] | n | X [%] |
|---|---|---|
| -2.3 | 3.05 | 75 |
| -2.25 | 3.16 | 57 |
| -2.2 | 3.23 | 45 |
| -2.15 | 3.28 | 36 |
| -2.1 | 3.32 | 30 |
| -2.05 | 3.35 | 26 |
| -2 | 3.36 | 23 |
| -1.95 | 3.37 | 21 |
| -1.9 | 3.38 | 20 |
| -1.85 | 3.38 | 20 |
| -1.8 | 3.38 | 19 |
| -1.75 | 3.38 | 19 |
| -1.7 | 3.38 | 19 |
| -1.65 | 3.38 | 20 |
| -1.6 | 3.38 | 20 |
| -1.55 | 3.38 | 20 |
| -1.5 | 3.38 | 20 |
| -1.45 | 3.38 | 21 |
| -1.4 | 3.38 | 21 |
| -1.35 | 3.37 | 21 |
| -1.3 | 3.37 | 21 |
| -1.25 | 3.37 | 21 |
| -1.2 | 3.37 | 21 |
| -1.15 | 3.37 | 21 |
| -1.1 | 3.37 | 21 |
| -1.05 | 3.37 | 21 |
| -1 | 3.37 | 22 |
| -0.95 | 3.37 | 22 |
| -0.9 | 3.37 | 22 |
| -0.85 | 3.37 | 22 |
| -0.8 | 3.37 | 22 |
| -0.75 | 3.37 | 22 |
| -0.7 | 3.37 | 22 |
| -0.65 | 3.37 | 22 |
| -0.6 | 3.37 | 22 |
| -0.55 | 3.37 | 22 |
| -0.5 | 3.37 | 22 |
| -0.45 | 3.37 | 22 |
| -0.4 | 3.37 | 22 |
| -0.35 | 3.37 | 22 |
| -0.3 | 3.37 | 22 |
| -0.25 | 3.37 | 22 |
| -0.2 | 3.37 | 22 |
| -0.15 | 3.37 | 22 |
| -0.1 | 3.37 | 22 |
| -0.05 | 3.37 | 22 |
| 0 | 3.37 | 22 |

| z [μm] | n | X [%] |
|---|---|---|
| 0.05 | 3.37 | 22 |
| 0.1 | 3.37 | 22 |
| 0.15 | 3.37 | 22 |
| 0.2 | 3.37 | 22 |
| 0.25 | 3.37 | 22 |
| 0.3 | 3.37 | 22 |
| 0.35 | 3.37 | 22 |
| 0.4 | 3.37 | 22 |
| 0.45 | 3.37 | 22 |
| 0.5 | 3.37 | 22 |
| 0.55 | 3.37 | 22 |
| 0.6 | 3.37 | 22 |
| 0.65 | 3.37 | 22 |
| 0.7 | 3.37 | 22 |
| 0.75 | 3.37 | 22 |
| 0.8 | 3.37 | 22 |
| 0.85 | 3.37 | 22 |
| 0.9 | 3.37 | 22 |
| 0.95 | 3.37 | 22 |
| 1 | 3.37 | 22 |
| 1.05 | 3.37 | 21 |
| 1.1 | 3.37 | 21 |
| 1.15 | 3.37 | 21 |
| 1.2 | 3.37 | 21 |
| 1.25 | 3.37 | 21 |
| 1.3 | 3.37 | 21 |
| 1.35 | 3.37 | 21 |
| 1.4 | 3.38 | 21 |
| 1.45 | 3.38 | 21 |
| 1.5 | 3.38 | 20 |
| 1.55 | 3.38 | 20 |
| 1.6 | 3.38 | 20 |
| 1.65 | 3.38 | 20 |
| 1.7 | 3.38 | 19 |
| 1.75 | 3.38 | 19 |
| 1.8 | 3.38 | 19 |
| 1.85 | 3.38 | 20 |
| 1.9 | 3.38 | 20 |
| 1.95 | 3.37 | 21 |
| 2 | 3.36 | 23 |
| 2.05 | 3.35 | 26 |
| 2.1 | 3.32 | 30 |
| 2.15 | 3.28 | 36 |
| 2.2 | 3.23 | 45 |
| 2.25 | 3.16 | 57 |
| 2.3 | 3.05 | 75 |

## FIG 3A

## FIG 3B

## FIG 4A

## FIG 4B

FIG 5A

FIG 5B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040013147 A1
- US 20040047379 A1
- DE 102007057773
- DE 102007061458

**In der Beschreibung aufgeführte Nicht-Patentliteratur**

- Handbook of Photonics. CRC Press